(19) Europäisches Patentamt
European Patent Office
Office européen des brevets

(11) EP 2 573 941 A1

(12) **EUROPEAN PATENT APPLICATION**
published in accordance with Art. 153(4) EPC

(43) Date of publication:
**27.03.2013 Bulletin 2013/13**

(21) Application number: **11803543.5**

(22) Date of filing: **04.07.2011**

(51) Int Cl.:
***H03M 7/30*** *(2006.01)* ***G10L 19/02*** *(2013.01)*
***H04N 7/26*** *(2006.01)*

(86) International application number:
**PCT/JP2011/065273**

(87) International publication number:
**WO 2012/005209 (12.01.2012 Gazette 2012/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.07.2010 JP 2010152950**

(71) Applicant: **Nippon Telegraph and Telephone Corporation**
**Tokyo 100-8116 (JP)**

(72) Inventors:
- **FUKUI, Masahiro**
**Musashino-shi**
**Tokyo 180-8585 (JP)**
- **SASAKI, Shigeaki**
**Musashino-shi**
**Tokyo 180-8585 (JP)**
- **HIWASAKI, Yusuke**
**Musashino-shi**
**Tokyo 180-8585 (JP)**
- **KOYAMA, Shoichi**
**Musashino-shi**
**Tokyo 180-8585 (JP)**
- **TSUTSUMI, Kimitaka**
**Musashino-shi**
**Tokyo 180-8585 (JP)**

(74) Representative: **MERH-IP**
**Matias Erny Reichl Hoffmann**
**Paul-Heyse-Strasse 29**
**80336 München (DE)**

# (54) ENCODING METHOD, DECODING METHOD, DEVICE, PROGRAM, AND RECORDING MEDIUM

(57) A quantized normalization value and a normalization-value quantization index corresponding to the quantized normalization value are obtained, the quantized normalization value being obtained by quantizing a normalization value that is a value representative of samples. If a difference value that is obtained by subtracting a value corresponding to the quantized normalization value from a value corresponding to a magnitude of a value of each sample is positive and if the value of each sample is positive, the difference value is set as a quantization candidate. If the difference value is positive and if the value of each sample is negative, a value obtained by inverting positive/negative of the difference value is set as the quantization candidate. The plurality of quantization candidates respectively corresponding to the plurality of samples are collectively vector-quantized, and a vector quantization index is thus obtained and output. Sign information is output, the sign information expressing positive/negative of each sample that does not make the difference value positive, among the samples. Accordingly, encoding and decoding techniques capable of reducing musical noise and the like can be provided.

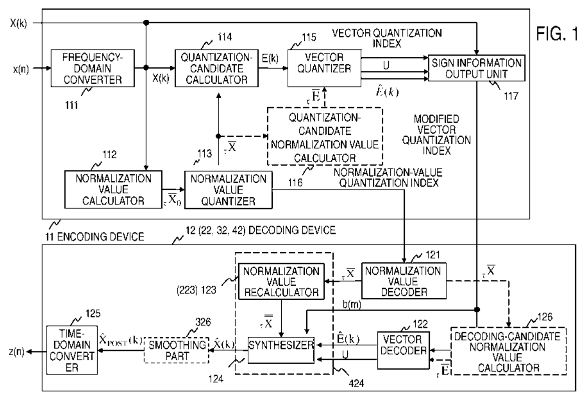

FIG. 1

EP 2 573 941 A1

## Description

[TECHNICAL FIELD]

The present invention relates to a technique of encoding or decoding, for example, a series of acoustic and video signals of sounds, music, and the like according to vector quantization.

[BACKGROUND ART]

In an encoding device described in Patent literature 1, an input signal is first divided by a normalization value, and the input signal is thus normalized. The normalization value is quantized, and a quantization index is generated. The normalized input signal is vector-quantized, and a representative quantization vector index is generated. The generated quantization index and the generated representative quantization vector index are output to a decoding device.

In the decoding device, the quantization index is decoded, and a normalization value is generated. In addition, the representative quantization vector index is decoded, and a sample sequence is generated. A sequence of values that are obtained by multiplying respective samples in the generated sample sequence by the normalization value corresponds to a decoded signal sample sequence.

For the vector quantization, for example, a vector quantization method such as algebraic vector quantization (AVQ) described in Non-patent literature 1 is applied to normalized values of a predetermined number of samples. In this vector quantization method, a representative quantization vector is obtained by giving pulses within a range of a quantization bit number set in advance. Then, in the obtained representative quantization vector, bits for expressing a sample value are assigned to only part of the predetermined number of samples, and a quantization value other than 0 is obtained. Further, bits for expressing a sample value are not assigned to the other samples, and the quantization value is 0.

[PRIOR ART LITERATURE]

[PATENT LITERATURE]

Patent literature 1: Japanese Patent Application Laid-Open No. 07-261800

[NON-PATENT LITERATURE]

Non-patent literature 1: Recommendation ITU-T G.718, SERIES G: TRANSMISSION SYSTEMS AND MEDIA, DIGITAL SYSTEMS AND NETWORKS, Digital terminal equipments - Coding of voice and audio signals, Frame error robust narrow-band and wideband embedded variable bit-rate coding of speech and audio from 8-32 kbit/s.

[SUMMARY OF THE INVENTION]

[PROBLEMS TO BE SOLVED BY THE INVENTION]

In the case where an input signal is, for example, a frequency-domain signal obtained by transforming an acoustic signal into a frequency-domain and where the above-mentioned vector quantization method is applied to the encoding device and the decoding device described in Patent literature 1, a spectral hole may occur if a bit number necessary to quantize every frequency component is not enough. The spectral hole refers to a partial loss in frequency components that is caused when a frequency component that should exist in an input signal does not exist in an output signal. If the occurrence of such a spectral hole prevents regular pulse rising of a given frequency component in a continuous frame, a problem of so-called musical noise unfavorably occurs. Such a problem of musical noise is particularly remarkable in the case where the encoding target is a frequency-domain signal, but similarly occurs in the case where the encoding target is a time-domain signal. In addition, in the case where an input signal is a video signal, a problem of block noise, which corresponds to musical noise in an acoustic signal, unfavorably occurs.

The present invention has an object to provide an encoding method, a decoding method, a device, a program, and a recording medium for reducing musical noise in an acoustic signal and block noise in a video signal.

[MEANS TO SOLVE THE PROBLEMS]

In encoding, a quantized normalization value and a normalization-value quantization index corresponding to the quantized normalization value are obtained, the quantized normalization value being obtained by quantizing a normalization value that is a value representative of a predetermined number of samples. If a difference value that is obtained by subtracting a value corresponding to the quantized normalization value from a value corresponding to a magnitude of a value of each sample is positive and if the value of each sample is positive, the difference value is set as a quantization candidate corresponding to each sample. If the difference value is positive and if the value of each sample is negative, a value obtained by inverting positive/negative of the difference value is set as the quantization candidate corresponding to each sample. The quantization candidate is vector-quantized, and a vector quantization index is thus obtained and output. In addition, sign information is output, the sign information expressing positive/negative of at least one sample that does not make the difference value positive, among the samples.

In decoding, a decoded normalization value corresponding to an input normalization-value quantization index is obtained, and a plurality of values corresponding to an input vector quantization index are obtained as a plurality of decoded values. With the use of a recalculated normalization value having a value that becomes smaller as a sum of absolute values of a predetermined number of the decoded values is larger, if each decoded value is 0 and if sign information corresponding to the decoded value is input, a value obtained by giving positive/negative expressed by the sign information to a product of the recalculated normalization value and a first constant is set as a decoded signal. If each decoded value is 0 and if the sign information corresponding to the decoded value is not input, a value having, as an absolute value, a value obtained by multiplying the recalculated normalization value by the first constant is set as the decoded signal. If each decoded value is not 0, a value obtained by reflecting positive/negative of each decoded value in a linear sum of each decoded value or the absolute value of each decoded value and the decoded normalization value is set as the decoded signal.

[EFFECTS OF THE INVENTION]

According to the present invention, main components containing samples that are not quantization targets according to vector quantization such as AVQ are selected from among every frequency, and the selected main components are aggressively quantized. Accordingly, a spectral hole can be prevented from occurring in main components of a decoded signal, and this can reduce musical noise in the case where an input signal is an acoustic signal and can reduce block noise in the case where an input signal is a video signal.

[BRIEF DESCRIPTION OF THE DRAWINGS]

Fig. 1 is a functional block diagram of examples of an encoding device and a decoding device;
Fig. 2 is a flow chart of an example of an encoding method;
Fig. 3 is a flow chart of an example of Step E3;
Fig. 4 is a flow chart of an example of Step E5;
Fig. 5 is a flow chart of an example of a decoding method;
Fig. 6 is a flow chart of an example of Step D3;
Fig. 7 is a flow chart of an example of Step D4;
Fig. 8 is a flow chart of an example of Step D4;
Fig. 9 is a flow chart of an example of Step D4;
Fig. 10 is a flow chart of Steps D3 and D4;
Fig. 11 is a flow chart of Steps D3 and D4; and
Fig. 12 is a graph illustrating a relation among an input signal, a quantization value, and sign information.

[DETAILED DESCRIPTION OF THE EMBODIMENTS]

Hereinafter, embodiments of the present invention are described in detail.

[FIRST EMBODIMENT]

First, a first embodiment of the present invention is described.

<Configuration>

As illustrated in Fig. 1, an encoding device 11 of the first embodiment includes, for example, a normalization value calculator 112, a normalization value quantizer 113, a quantization-candidate calculator 114, a vector quantizer 115, and a sign information output unit 117. As illustrated in Fig. 1, a decoding device 12 of the first embodiment includes, for example, a normalization value decoder 121, a vector decoder 122, a normalization value recalculator 123, and a synthesizer 124. As needed, the encoding device 11 may include, for example, a frequency-domain converter 111 and a quantization-candidate normalization value calculator 116. The decoding device 12 may include, for example, a time-domain converter 125 and a decoding-candidate normalization value calculator 126.

<Encoding Process>

The encoding device 11 executes steps in an encoding method illustrated in Fig. 2.
An input signal X(k) is input to the normalization value calculator 112, the quantization-candidate calculator 114, and the sign information output unit 117. The input signal X(k) in this example is a frequency-domain signal obtained by transforming, into a frequency-domain, a time-domain signal x(n) that is a time-series signal such as an acoustic signal. The input signal X(k) in the frequency-domain may be directly input to the encoding device 11, and the frequency-domain converter 111 may transform the input time-domain signal x(n) into a frequency-domain to generate the input signal X (k) in the frequency-domain. In the case where the frequency-domain converter 111 generates the input signal X(k) in the frequency domain, the frequency-domain converter 111 transforms the input time-domain signal x(n) into the input signal X(k) in the frequency-domain according to, for example, modified discrete cosine transform (MDCT), and outputs the resultant signal. n denotes an identification number (discrete time number) of a signal in a time-domain, and k denotes an identification number (discrete frequency number) of a signal (sample) in a frequency-domain. A larger value of k corresponds to a higher frequency. Assuming that one frame is constituted by L samples, the time-domain signals x(n) are transformed into a frequency-domain for each frame, and the input signals X(k) in the frequency-domain (k = 0, 1, ..., L-1) constituting L frequency components are generated. L is a predetermined positive number, for example, 64 or 80. Note that, in the case of using the MDCT, input time-series signals are transformed into a frequency-domain for each frame constituted by the L samples, at a timing of a 1 / 2 frame, that is, at a timing of a L / 2 sample.
The normalization value calculator 112 calculates a normalization value ${}_{\tau}X_0^-$ for each frame (Step E1), and the normalization value ${}_{\tau}X_0^-$ is a value representative of a predetermined number $C_0$ of samples among the L samples of the input signals X(k). ${}_{\tau}X_0^-$ means ${}_{\tau}X_0$ with an overline. Here, τ is assumed to be an integer that is equal to or more than 0 and is uniquely assigned to each subband constituted by the predetermined number $C_0$ of samples among the L samples in one frame. $C_0$ is L or a common divisor of L other than 1 and L. Note that setting L to $C_0$ means obtaining the normalization value on an L-sample basis. Setting a common divisor of L other than 1 and L to $C_0$ means dividing the L samples into subbands and obtaining the normalization value on a $C_0$-sample basis, the $C_0$ samples constituting each subband. For example, in the case where L is equal to 64 and where each subband is constituted by 8 frequency components, 8 subbands are formed, and the normalization value for each subband is calculated. In addition, in the case where $C_0$ is L, τ is equal to 0, and the normalization value ${}_{\tau}X_0^-$ is a value representative of the L samples. That is, in the case where $C_0$ is L, one normalization value ${}_{\tau}X_0^-$ is calculated for each frame. On the other hand, in the case where $C_0$ is a common divisor of L other than 1 and L, τ is an integer (τ = 0, ..., (L / $C_0$) - 1) corresponding to each subband in one frame, and the normalization value ${}_{\tau}X_0^-$ is a value representative of the $C_0$ samples that belong to each subframe corresponding to τ. That is, in the case where $C_0$ is a common divisor of L other than 1 and L, (L / $C_0$) normalization values ${}_{\tau}X_0^-$ (τ = 0, ..., (L / $C_0$) - 1) are calculated for each frame. In addition, k is equal to τ. $C_0$, ..., (τ + 1) · $C_0$ - 1, irrespective of a value of $C_0$. ${}_{\tau}X_0^-$ calculated by the normalization value calculator 112 is sent to the normalization value quantizer 113.

[Specific Examples of Normalization Value ${}_{\tau}X_0^-$]

The normalization value ${}_{\tau}X_0^-$ is a value representative of the $C_0$ samples. In other words, the normalization value ${}_{\tau}X_0^-$ is a value corresponding to the $C_0$ samples. An example of the normalization value ${}_{\tau}X_0^-$ is the following square root to a power average value of the $C_0$ samples.
$$_{\tau}\overline{X}_0 = \sqrt{\frac{\sum_{k=\tau\cdot C_0}^{(\tau+1)\cdot C_0 - 1} X(k)^2}{C_0}}$$

Another example of the normalization value $_{\tau}X_0^-$ is the following value, which is obtained by dividing, by $C_0$, the square root to a total power value of the $C_0$ samples.

$$_{\tau}\overline{X}_0 = \frac{\sqrt{\sum_{k=\tau\cdot C_0}^{(\tau+1)\cdot C_0 - 1} X(k)^2}}{C_0}$$

Still another example of the normalization value $_{\tau}X_0^-$ is the following average amplitude value of the $C_0$ samples.

$$_{\tau}\overline{X}_0 = \frac{\sum_{k=\tau\cdot C_0}^{(\tau+1)\cdot C_0 - 1} |X(k)|}{C_0}$$

(End of Description of [Specific Examples of Normalization Value $_{\tau}X_0^-$])

The normalization value quantizer 113 quantizes the normalization value $_{\tau}X_0^-$, to thereby obtain a quantized normalization value $_{\tau}X^-$, and also obtains a normalization-value quantization index corresponding to the quantized normalization value $_{\tau}X^-$ (Step E2). $_{\tau}X^-$ means $_{\tau}X$ with an overline. The quantized normalization value $_{\tau}X^-$ is sent to the quantization-candidate calculator 114, and a code (bit stream) corresponding to the normalization-value quantization index is sent to the decoding device 12.

The quantization-candidate-quantization-candidate calculator 114 subtracts a value corresponding to the quantized normalization value from a value corresponding to the magnitude of the value X(k) of each sample of the input signal, to thereby calculate a difference value E(k)'. In the case where the difference value E(k)' is positive and where the value X(k) of each sample is positive, the quantization-candidate calculator 114 sets the difference value E(k)' as a quantization candidate E(k) corresponding to each sample. In the case where the difference value E(k)' is positive and where the value X(k) of each sample is negative, the quantization-candidate calculator 114 sets a value obtained by inverting the positive/negative of the difference value, as the quantization candidate E(k) corresponding to each sample. In the case where the difference value E(k)' is not positive, the quantization-candidate calculator 114 sets 0 as the quantization candidate E(k) corresponding to each sample. Examples of the value corresponding to the magnitude of the value X(k) of each sample include: an absolute value of the value X(k) of each sample; a value proportional to an absolute value of the value X(k) of each sample; a value obtained by multiplying an absolute value of the value X(k) of each sample by a constant or a variable $\theta$; and an absolute value of a value obtained by multiplying the value X(k) of each sample by a constant and/or a variable. Examples of the value corresponding to the quantized normalization value include: the quantized normalization value; a value proportional to the quantized normalization value; and a value obtained by multiplying the quantized normalization value by a constant and/or a variable (Step E3). The quantization candidate E(k) is sent to the vector quantizer 115.

[Specific Example 1 of Step E3]

For example, the quantization-candidate calculator 114 performs processing illustrated in Fig. 3, and decides the quantization candidate E(k) corresponding to the value X(k) of each sample of the input signal. Note that the processing illustrated in Fig. 3 is executed for each $\tau$ described above. That is, in the case where $C_0$ is L, the processing illustrated in Fig. 3 is executed for each frame. In the case where $C_0$ is a common divisor of L other than 1 and L, the processing illustrated in Fig. 3 is repeatedly executed for each subband in one frame.
The quantization-candidate calculator 114 sets $\tau \cdot C_0$ to k, to thereby initialize a value of k (Step E31).
The quantization-candidate calculator 114 compares k with $(\tau + 1) \cdot C_0$. If k is less than $(\tau + 1) \cdot C_0$, the quantization-candidate calculator 114 goes to Step E33. If k is not less than $(\tau + 1) \cdot C_0$, the quantization-candidate calculator 114 ends the processing of Step E3 (Step E32). Note that a comparison method for "comparing $\delta$ with $\eta$" is not limited, and any comparison method may be adopted as long as the adopted method can determine a magnitude relation between $\delta$ and $\eta$. For example, a process of comparing $\delta$ with $\eta$ in order to know whether or not $\delta < \eta$ is satisfied may be a process of determining whether or not $\delta < \eta$ is satisfied, may be a process of determining whether or not $0 < \eta - \delta$ is satisfied, may be a process of determining whether or not $\delta \geq \eta$ is satisfied, and may be a process of determining whether or not $0 \geq \eta - \delta$ is satisfied.
In Step E33, the quantization-candidate calculator 114 subtracts a value corresponding to the quantized normalization value from a value corresponding to an absolute value of the value X(k) of each sample of the input signal, to thereby calculate the difference value E(k)' (Step E33). For example, the quantization-candidate calculator 114 calculates a value of E(k)' defined by the following Equation (1). $C_1$ is an adjustment constant of the normalization value, and has a positive value. $C_1$ is, for example, 1.0. $|\cdot|$ expresses an absolute value of .
$$E(k)' = |X(k)| - C_1 \cdot {}_{\tau}\overline{X} \quad \cdots (1)$$

The quantization-candidate calculator 114 compares the difference value E(k)' with 0 (Step E34). If E(k)' is not equal to or more than 0, the quantization-candidate calculator 114 updates E(k)' to 0 (Step E35), and goes to Step E36. If E(k)' is equal to or more than 0, the quantization-candidate calculator 114 goes to Step E36 without updating E(k)'.
In Step E36, the quantization-candidate calculator 114 compares X(k) with 0 (Step E36). If X(k) is not less than 0, the quantization-candidate calculator 114 sets E(k)' to the quantization candidate E(k) (Step E37). If X(k) is less than 0, the quantization-candidate calculator 114 sets -E(k)', which is obtained by inverting the positive/negative of E(k)', to the quantization candidate E(k) (Step E38).
The quantization-candidate calculator 114 increments k by 1 (updates a value of k by setting k + 1 as a new value of k), and goes to Step E32 (Step E39).

[Specific Example 2 of Step E3]

The quantization-candidate calculator 114 may decide the quantization candidate E(k) corresponding to the value X(k) of each sample of the input signal, for example, in the following manner.
The quantization-candidate calculator 114 sets 0 to k, to thereby initialize a value of k (Step E31).
The quantization-candidate calculator 114 compares k with $C_0$ (Step E32). If k is less than $C_0$, the quantization-candidate calculator 114 goes to Step E33. If k is not less than $C_0$, the quantization-candidate calculator 114 ends the processing of Step E3.
The quantization-candidate calculator 114 subtracts a value corresponding to the quantized normalization value from a value corresponding to an absolute value of the value X(k) of each sample of the input signal, to thereby calculate the difference value E(k)' (Step E33).
The quantization-candidate calculator 114 compares the difference value E(k)' with 0 (Step E34). If E(k)' is not equal to or more than 0, the quantization-candidate calculator 114 sets 0 to E(k) (Step E35'), increments k by 1 (Step E39), and goes to Step E32. If E(k)' is equal to or more than 0, the quantization-candidate calculator 114 compares X (k) with 0 (Step E36). If X(k) is not less than 0, the quantization-candidate calculator 114 sets E(k)' to the quantization candidate E(k) (Step E37). If X(k) is less than 0, the quantization-candidate calculator 114 sets -E(k)', which is obtained by inverting the positive/negative of E(k)', to the quantization candidate E(k) (Step E38). The quantization-candidate calculator 114 increments k by 1, and goes to Step E32 (Step E39).
In this way, the quantization-candidate calculator 114 selects a larger value of 0 and the difference value, which is obtained by subtracting a value corresponding to the quantized normalization value from a value corresponding to the magnitude of a sample value, and decides a value obtained by multiplying the selected value by the sign of the sample value, as the quantization candidate.

[Specific Example 3 of Step E3]

According to Specific Examples 1 and 2 of Step E3, the processing is branched in Step E34 depending on whether or not E(k)' is equal to or more than 0. Alternatively, the processing may be branched in Step E34 depending on whether or not E(k)' is more than 0 (End of Description of [Specific Examples of Step E3]).
The vector quantizer 115 collectively vector-quantizes the plurality of quantization candidates E(k) respectively corresponding to a plurality of samples, to thereby generate a vector quantization index.

The vector quantization index is an index that expresses a representative quantization vector. For example, the vector quantizer 115 selects a representative quantization vector that is the closest to a vector having, as its components, the plurality of quantization candidates E(k) corresponding to the plurality of samples, from among a plurality of representative quantization vectors stored in a vector code book storing part (not illustrated), and outputs a vector quantization index that expresses the selected representative quantization vector, to thereby perform the vector quantization. For example, the vector quantizer 115 collectively vector-quantizes the quantization candidates E(k) corresponding to the $C_0$ samples. In the case where the quantization candidate E(k) is 0, the vector quantizer 115 performs the vector quantization using such a quantizing method that always makes a quantization value E^(k) 0, for example, a vector quantization method such as algebraic vector quantization (AVQ; see G.718). In this way, in the case where the input signal is, for example, a frequency-domain signal, main components containing samples that are not quantization targets according to vector quantization such as AVQ are selected from among every frequency, and the selected main components are aggressively quantized. Accordingly, a spectral hole can be prevented from occurring in main components of a decoded signal, and this can reduce musical noise and block noise (the musical noise and the block noise are hereinafter collectively referred to as "musical noise and the like").

In addition, the bit number of a code obtained by the vector quantization varies depending on the input signal. For some input signals, the bit number of a code (the vector quantization index and the like) obtained by the vector quantization may be less than a bit number assigned for the vector quantization, and part of bits assigned for the vector quantization may remain unused. Note that the "bits assigned for the vector quantization" mean bits assigned for a code (a code corresponding to the vector quantization index) obtained by the vector quantization, among codes sent from the encoding device 11 to the decoding device 12. The "bit number assigned for the vector quantization" means the bit number of the bits assigned for the vector quantization. The "bit number assigned for the vector quantization" may be determined for each frame, and may be determined for each subband. In addition, the "bit number assigned for the vector quantization" may vary depending on the input signal, and may be constant irrespective of the input signal. The vector quantizer 115 calculates, as an unused bit number U, the bit number of bits that are not used in actual vector quantization, among the bits assigned for the vector quantization. In the present embodiment, the unused bit number U is calculated for each frame (on an L-sample basis). For example, the vector quantizer 115 subtracts, from the bit number assigned for the vector quantization in a given frame to be processed, the total bit number of the vector quantization index obtained by vector-quantizing the L samples that actually belong to the given frame, and sets the resultant value as the unused bit number U.

Further, the vector quantizer 115 outputs the plurality of quantization values E^(k), which are values obtained by locally decoding the vector quantization index. For example, the vector quantizer 115 outputs respective components of the representative quantization vector expressed by the vector quantization index, as the quantization values E^(k). The quantization value E^(k) in this example is equal to a decoded value E^(k) obtained by the decoding device 12. Note that the quantization value E^(k) does not necessarily need to be identical with the decoded value E^(k), and a decoded value E^(k)', which is 0 in the case where the quantization value E^(k) is 0 and is 0 in the case where the quantization value E^(k) is not 0, may be used in place of the decoded value E^(k). Note that E^ means E with a circumflex.

The vector quantizer 115 sends the vector quantization index, the unused bit number U, and the quantization value E^(k) to the sign information output unit 117 (Step E4).

The sign information output unit 117 writes the sign information of a sample that makes the quantization value E^(k) 0, of the input signal X(k) in the frequency-domain, into a region of unused bits (referred to as "unused bit region") among the bits assigned for the vector quantization. In other words, the sign information output unit 117 places the sign information that expresses the positive/negative of the value X(k) of each sample that does not make E(k)' positive (makes E(k)' equal to or less than 0), into the unused bit region of a code (bit stream) corresponding to the vector quantization index (Step E5). Note that the unused bit region can be identified by, for example, a reference position (for example, an initial address) of a given unused bit region and the input unused bit number U.

As a result, the unused bit region can be effectively utilized, and the quality of decoded signals can be enhanced. Note that the upper limit of the bit number of the sign information written into the unused bit region is the unused bit number U. Accordingly, all pieces of the sign information are necessarily written into the unused bit region. Under the circumstances, it is preferable that the sign information output unit 117 extracts the sign information in accordance with criteria defined by considering auditory perceptual characteristics and writes the extracted sign information into the unused bit region. For example, the sign information output unit 117 preferentially extracts the sign information of the input signal X(k) in the frequency domain at frequencies easily perceived by human beings, and writes the extracted sign information into the unused bit region.

[Specific Example of Step E5]

A simple example for simplifying the processing is described. Assuming that auditory perceptual characteristics become lower in a higher frequency region, the sign information corresponding to the unused bit number U is written over the unused bit region in order from a lower frequency. In this example, the sign information output unit 117 performs processing illustrated in Fig. 4, and writes the sign information of a sample that makes the quantization value E^(k) 0, of the input signal X(k) in the frequency-domain, into the unused bit region. Note that Fig. 4 illustrates the processing on the $C_0$ samples, and the processing illustrated in Fig. 4 is executed for each $\tau$ described above. That is, in the case where $C_0$ is L, the processing of Step E5 in Fig. 4 is executed for each frame. In the case where $C_0$ is a common divisor of L other than 1 and L, the processing of Step E5 in Fig. 4 is repeatedly executed for each subband in one frame.

The sign information output unit 117 sets $\tau \cdot C_0$ to k, and sets 0 to m, to thereby initialize values of k and m, and goes to Step E52 (Step E51).

The sign information output unit 117 compares k with $(\tau + 1) \cdot C_0$ (Step E52). If k is less than $(\tau + 1) \cdot C_0$, the sign information output unit 117 goes to Step E53. If k is not less than $(\tau + 1) \cdot C_0$, the sign information output unit 117 sets a region obtained by subtracting a region in which bits b(m) are placed from the unused bit region, as a new unused bit region, sets U - m as a new value of U (Step E510), and ends the processing of Step E5. Note that, in the case where $C_0$ is L, Step E510 does not necessarily need to be executed.

The sign information output unit 117 compares m with U (Step E53). If m is less than U, the sign information output unit 117 goes to Step E54. If m is not less than U, the sign information output unit 117 increments k by 1 (Step E55), and goes to Step E52.

In Step E54, the sign information output unit 117 determines whether or not E^(k) is 0 (Step E54). If E^(k) is not equal to 0, the quantization-candidate calculator 114 increments k by 1 (Step E55), and goes to Step E52. If E^(k) is equal to 0, the quantization-candidate calculator 114 compares X(k) with 0 (Step E56). If X(k) is less than 0, the quantization-candidate calculator 114 writes 0 into the $m^{th}$ bit b(m) in the unused bit region (Step E57), and goes to Step E59. If X(k) is not less than 0, the quantization-candidate calculator 114 writes 1 into the $m^{th}$ bit b(m) in the unused bit region (Step E58), and goes to Step E59. Note that a determination method for "determining whether or not $\delta$ is 0" is not limited, and any determination method may be adopted as long as the adopted method can make a determination corresponding to whether or not $\delta$ is 0. For example, whether or not $\delta$ is 0 may be determined by determining whether or not $\delta$ is equal to 0, may be determined by determining whether or not $\delta$ is equal to $\gamma$ ($\gamma$ is not equal to 0), and may be determined by determining whether or not $\delta > 0$ and $\delta < 0$ are satisfied.

In Step E59, the quantization-candidate calculator 114 increments m by 1 (Step E59), increments k by 1 (Step E55), and goes to Step E52.

Fig. 12 is a graph illustrating a relation among the input signal, the quantization value, and the sign information. The horizontal axis of Fig. 12 expresses an identification number k of a sample corresponding to each frequency, and the vertical axis thereof expresses an MDCT coefficient. The broken line graph expresses the input signal X(k) in the frequency-domain, and the solid line graph expresses the quantization value E^(k). Fig. 12 illustrates an example of the case where the unused bit number U is 6. In this example, six of the identification numbers k that make E^(k) equal to 0 are selected in order from the smallest value, and the positive/negative ("+" or "-") of X(k) corresponding to each of the selected identification numbers k is written into the bit b(m) (m = 0, ..., 5) in the unused bit region (End of Description of [Specific Example of Step E5]).

A code (bit stream) corresponding to a modified vector quantization index containing the vector quantization index and the sign information written into the unused bit region is sent to the decoding device 12.

Note that, in the case of adopting, for the vector quantizer 115, a quantizing method in which the quantization value E(k)' may not be 0 even in the case where the quantization candidate E(k) is 0, the vector quantizer 115 may vector-quantize only the quantization candidates E(k) having a value other than 0, and the sign information output unit 117 may output the sign information of a sample that makes the quantization candidate E(k) 0, of the input signal X(k) in the frequency-domain. In this case, however, it is necessary to output and report, to the decoding device, the sample identification number k of the sample that makes the quantization candidate E(k) 0 or the sample identification number k of a sample that does not make the quantization candidate E(k) 0. For this reason, it is preferable that a vector quantization method in which the quantization value E(k)' is always 0 in the case where the quantization candidate E(k) is 0 be adopted for the vector quantizer 115.

<Decoding Process>

The decoding device 12 executes steps in a decoding method illustrated in Fig. 5.
The normalization value decoder 121 obtains a decoded normalization value ${}_{\tau}X^{-}$ corresponding to the normalization-value quantization index input to the decoding device 12 (Step D1). The decoded normalization value ${}_{\tau}X^{-}$ is sent to the normalization value recalculator 123. It is assumed that a normalization value corresponding to each of the plurality of normalization-value quantization indexes is stored in a code book storing part (not illustrated). The normalization value decoder 121 refers to the code book storing part using the input normalization quantization index as a key, and acquires a normalization value corresponding to the input normalization-value quantization index, as the decoded normalization value ${}_{\tau}X^{-}$.

The vector decoder 122 obtains, as the plurality of decoded values E^(k), a plurality of values corresponding to the vector quantization index contained in the modified vector quantization index input to the decoding device 12. In addition, the vector decoder 122 calculates the unused bit number U using the vector quantization index (Step D2). The decoded values E^(k) and the unused bit number U are sent to the synthesizer 124.

For example, it is assumed that a representative quantization vector corresponding to each of the plurality of vector quantization indexes is stored in a vector code book storing part (not illustrated). The vector decoder 122 refers to the vector code book storing part using a representative quantization vector corresponding to the input vector quantization index as a key, and acquires the representative quantization vector corresponding to the input vector quantization index. Components of the representative quantization vector are the plurality of values corresponding to the input vector quantization index.

In addition, the vector decoder 122 calculates, as the unused bit number U, the bit number of bits that are not used in actual vector quantization, among the bits assigned for the vector quantization. In the present embodiment, the unused bit number U is calculated for each frame (on an L-sample basis). For example, the vector decoder 122 subtracts, from the bit number assigned for the vector quantization in a given frame to be processed, the total bit number of the vector quantization index corresponding to the given frame, and sets the resultant value as the unused bit number U.

The normalization value recalculator 123 calculates a recalculated normalization value ${}_{\tau}X^{=}$ having a value that becomes smaller as the sum of absolute values of a predetermined number of the decoded values E^(k) is larger (Step D3). The calculated recalculated normalization value ${}_{\tau}X^{=}$ is sent to the synthesizer 124. The recalculated normalization value ${}_{\tau}X^{=}$ means ${}_{\tau}X$ with a double overline.

[Specific Example of Step D3]

For example, the normalization value recalculator 123 performs processing illustrated in Fig. 6, to thereby obtain a value of the recalculated normalization value ${}_{\tau}X^{=}$. The recalculated normalization value ${}_{\tau}X^{=}$ is a value representative of samples that make the quantization candidate E(k) 0 in the encoding process. In this example, as shown in the following Equation (2), a total power value tmp of the samples that do not make the quantization candidate E(k) 0 in the encoding process is subtracted from a total power value $C_0 \cdot {}_{\tau}X^{-2}$ of the $C_0$ samples, the resultant value is divided by a number m of the samples that make the quantization candidate E(k) 0, and the square root of the resultant value is obtained, whereby the recalculated normalization value ${}_{\tau}X^{=}$ is calculated. Note that the processing illustrated in Fig. 6 is executed for each τ described above.

The normalization value recalculator 123 sets $\tau \cdot C_0$ to k, sets 0 to m, and sets 0 to tmp, to thereby initialize these values k, m, and tmp (Step D31).
The normalization value recalculator 123 compares k with $(\tau + 1) \cdot C_0$ (Step D32). If k is equal to or more than $(\tau + 1) \cdot C_0$, the normalization value recalculator 123 calculates a value of ${}_{\tau}X^{=}$ defined by the following equation (Step D37), and ends the processing of Step D3.

$${}_{\tau}\overline{\overline{X}} = \sqrt{\frac{C_0 \cdot {}_{\tau}\overline{X}^2 - \mathrm{tmp}}{m}} \quad \cdots (2)$$

If k is less than $(\tau + 1) \cdot C_0$, the normalization value recalculator 123 determines whether or not the decoded value E^(k) is 0 (Step D33). If the decoded value E^(k) is 0, the normalization value recalculator 123 increments m by 1 (Step D35), and goes to Step D36. If the decoded value E^(k) is not 0, the normalization value recalculator 123 goes to Step D34.

The normalization value recalculator 123 calculates the power of the sample of the identification number k, and adds the calculated power to tmp (Step D34). After that, the normalization value recalculator 123 goes to Step D36. That is, the normalization value recalculator 123 sets a value obtained by adding the calculated power to a value of tmp, as a new value of tmp. For example, the normalization value recalculator 123 calculates the power according to the following equation.

$$\left(C_1 \cdot {}_{\tau}\overline{X} + |\hat{E}(k)|\right)^2$$

The normalization value recalculator 123 increments k by 1 (Step D36), and goes to Step D32 (End of Description of [Specific Example of Step D3]).

In the case where each decoded value E^(k) is positive, the synthesizer 124 calculates the linear sum of each decoded value E^(k) and the decoded normalization value $_{\tau}X^{-}$. In the case where each decoded value E^(k) is negative, the synthesizer 124 calculates the positive/negative inverted value of the linear sum of: an absolute value of each decoded value E^(k); and the decoded normalization value $_{\tau}X^{-}$. In the case where each decoded value E^(k) is 0, the synthesizer 124 calculates the multiplication value of the recalculated normalization value $_{\tau}X^{=}$ and a first constant $C_3$ or the positive/negative inverted value of the multiplication value thereof. In this way, the synthesizer 124 obtains a value X^(k) of the decoded signal.

Here, for a sample that makes the decoded value E^(k) 0 and whose positive/negative is expressed by the sign information contained in the modified vector quantization index, the positive/negative of X^(k) of the sample is identified by the corresponding sign information. That is, for a sample that makes the decoded value E^(k) 0 and is expressed as positive by the sign information, the multiplication value of the recalculated normalization value $_{\tau}X^{=}$ and the first constant $C_3$ is X^(k). For a sample that makes the decoded value E^(k) 0 and is expressed as negative by the sign information, the positive/negative inverted value of the multiplication value of the recalculated normalization value $_{\tau}X^{=}$ and the first constant $C_3$ is X^(k). Further, for a sample that makes the decoded value E^(k) 0 and whose positive/negative is not identified by the sign information, the positive/negative of X^(k) is randomly determined. That is, a value obtained by randomly inverting the positive/negative of the multiplication value of the recalculated normalization value $_{\tau}X^{=}$ and the first constant $C_3$ is X^(k) (Step D4). In the present embodiment, the positive/negative of X^(k) can be identified by the sign information that is transmitted using the unused bit region, and hence the quality of X^(k) can be enhanced.

[Specific Example 1 of Step D4]

The synthesizer 124 performs, for example, processing illustrated in Fig. 7, to thereby obtain the decoded signal. Note that the processing illustrated in Fig. 7 is executed for each τ described above. That is, in the case where $C_0$ is L, the processing of Step D4 in Fig. 7 is executed for each frame. In the case where $C_0$ is a common divisor of L other than 1 and L, the processing of Step D4 in Fig. 7 is repeatedly executed for each subband in one frame.

The synthesizer 124 sets $\tau \cdot C_0$ to k, and sets 0 to m, to thereby initialize values of k and m (Step D41).

The synthesizer 124 compares k with $(\tau + 1) \cdot C_0$ (Step D42). If k is not less than $(\tau + 1) \cdot C_0$, the synthesizer 124 sets a region obtained by subtracting a region in which the bits b(m) are placed from the unused bit region, as a new unused bit region, sets U - m as a new value of U (Step D414), and ends the processing of Step D4. Note that, in the case where $C_0$ is L, Step D414 does not necessarily need to be executed. If k is less than $(\tau + 1) \cdot C_0$, the synthesizer 124 determines whether or not the decoded value E^(k) is 0 (Step D43). If the decoded value E^(k) is 0, the synthesizer 124 compares m with the unused bit number U (Step D44). If m is not less than U, the synthesizer 124 sets a value obtained by randomly inverting the positive/negative of the multiplication value of the recalculated normalization value $_{\tau}X^{=}$ and the first constant $C_3$, as the value X^(k) of the decoded signal (Step D45). That is, the synthesizer 124 calculates, as X^(k), a value defined by the following equation. $C_3$ is a constant that adjusts the magnitude of frequency components. $C_3$ in this example is a positive constant, and is, for example, 0.9. rand(k) is a function that outputs 1 or -1, and randomly outputs 1 or -1 on the basis of, for example, a random number.

In this way, the synthesizer 124 sets, as X^(k), a value having, as an absolute value, the value obtained by multiplying the recalculated normalization value $_{\tau}X^{=}$ by the first constant $C_3$.

$$\hat{X}(k) = C_3 \cdot {}_\tau\overline{\overline{X}} \cdot \mathrm{rand}(k)$$

After Step D45, the synthesizer 124 increments k by 1 (Step D413), and goes to Step D42.
If it is determined in Step D44 that m is less than U, the synthesizer 124 determines whether or not the $m^{th}$ bit b(m) in the input unused bit region is 0 (Step D46) (Note that the position of the $m^{th}$ bit b(m) in the unused bit region contained in the modified vector quantization index is determined by a start bit position of the unused bit region and the placement order of the bits b(m), and can be easily identified if the unused bit number U is obtained). If b(m) is 0, the synthesizer 124 sets a value obtained by inverting the positive/negative of the multiplication value of the recalculated normalization value ${}_\tau X^=$ and the first constant $C_3$, as the value X^(k) of the decoded signal (Step D47). That is, the synthesizer 124 calculates, as X^(k), a value defined by the following equation.
$$\hat{X}(k) = -C_3 \cdot {}_\tau\overline{\overline{X}}$$

After Step D47, the synthesizer 124 increments each of m and k by 1 (Steps D412 and D413), and goes to Step D42.
If it is determined in Step D46 that b(m) is not 0, the synthesizer 124 sets the multiplication value of the recalculated normalization value ${}_\tau X^=$ and the first constant $C_3$, as the value X^(k) of the decoded signal (Step D48). That is, the synthesizer 124 calculates, as X^(k), a value defined by the following equation.
$$\hat{X}(k) = C_3 \cdot {}_\tau\overline{\overline{X}}$$

After Step D48, the synthesizer 124 increments each of m and k by 1 (Steps D412 and D413), and goes to Step D42.
On the other hand, if it is determined in Step D43 that the decoded value E^(k) is not 0, the synthesizer 124 compares the decoded value E^(k) with 0 (Step D49). If the decoded value E^(k) is less than 0, the synthesizer 124 adds the absolute value |E^(k)| of the decoded value E^(k) to the decoded normalization value ${}_\tau X^-$, inverts the positive/negative of the resultant value, and sets the resultant value as the value X^(k) of the decoded signal (Step D410). That is, the synthesizer 124 calculates, as X^(k), a value defined by the following equation.
$$\hat{X}(k) = -\left(C_1 \cdot {}_\tau\overline{X} + |\hat{E}(k)|\right)$$

If the decoded value E^(k) is not less than 0, the synthesizer 124 sets, as X^(k), a value obtained by adding the decoded value E^(k) to the decoded normalization value ${}_\tau X^-$ (Step D411).
$$\hat{X}(k) = C_1 \cdot {}_\tau\overline{X} + \hat{E}(k)$$

As described above, in the case where E^(k) is not equal to 0, the synthesizer 124 calculates X^(k) determined by X^(k) = σ(E^(k)) · ($C_1$ · ${}_\tau X^-$ + |E^(k)|). Here, σ(·) expresses the positive/negative sign of ·.
After Steps D410 and D411, the synthesizer 124 increments k by 1 (Step D48), and goes to Step D42.

[Specific Example 2 of Step D4]

The synthesizer 124 may perform, for example, processing illustrated in Fig. 8 and Fig. 9, to thereby obtain the decoded signal. Note that the processing illustrated in Fig. 8 and Fig. 9 is executed for each $\tau$ described above. That is, in the case where $C_0$ is L, the processing in Fig. 8 and Fig. 9 is executed for each frame. In the case where $C_0$ is a common divisor of L other than 1 and L, the processing in Fig. 8 and Fig. 9 is repeatedly executed for each subband in one frame.
The synthesizer 124 sets $\tau \cdot C_0$ to k, to thereby initialize a value of k (Step D421).
The synthesizer 124 compares k with $(\tau + 1) \cdot C_0$ (Step D422). If k is not less than $(\tau + 1) \cdot C_0$, the synthesizer 124 goes to Step D429. If k is less than $(\tau + 1) \cdot C_0$, the synthesizer 124 determines whether or not the decoded value E^(k) is 0 (Step D423). If the decoded value E^(k) is 0, the synthesizer 124 sets a value obtained by randomly inverting the positive/negative of the multiplication value of the recalculated normalization value $_\tau X^=$ and the first constant $C_3$, as the value X^(k) of the decoded signal (Step D424). That is, the synthesizer 124 calculates, X^(k), as a value defined by the following equation.
In this way, the synthesizer 124 sets, as X^(k), a value having, as an absolute value, the value obtained by multiplying the recalculated normalization value $_\tau X^=$ by the first constant $C_3$.
$$\hat{X}(k) = C_3 \cdot {}_\tau \overline{\overline{X}} \cdot \mathrm{rand}(k)$$

If it is determined in Step D423 that the decoded value E^(k) is not 0, the synthesizer 124 compares the decoded value E^(k) with 0 (Step D425). If the decoded value E^(k) is less than 0, the synthesizer 124 adds the absolute value |E^(k)| of the decoded value E^(k) to the decoded normalization value $_\tau X^-$, inverts the positive/negative of the resultant value, and sets the resultant value as the value X^(k) of the decoded signal (Step D426). That is, the synthesizer 124 calculates, as X^(k), a value defined by the following equation.
$$\hat{X}(k) = -\left(C_1 \cdot {}_\tau \overline{X} + |\,\hat{E}(k)\,|\right)$$

If the decoded value E^(k) is not less than 0, the synthesizer 124 sets, as X^(k), a value obtained by adding the decoded value E^(k) to the decoded normalization value $_\tau X^-$ (Step D427).
$$\hat{X}(k) = C_1 \cdot {}_\tau \overline{X} + \hat{E}(k)$$

The synthesizer 124 increments k by 1 (Step D428) after deciding X^(k), and goes to Step D422.
In Step D429, the synthesizer 124 sets $\tau \cdot C_0$ to k, and sets 0 to m, to thereby initialize values of k and m (Step D429).
The synthesizer 124 compares k with $(\tau + 1) \cdot C_0$ (Step D430). If k is not less than $(\tau + 1) \cdot C_0$, the synthesizer 124 sets a region obtained by subtracting a region in which the bits b(m) are placed from the unused bit region, as a new unused bit region, sets U - m as a new value of U (Step D438), and ends the processing of Step D4. Note that, in the case where $C_0$ is L, Step D438 does not necessarily need to be executed. If k is less than $(\tau + 1) \cdot C_0$, the synthesizer 124 compares m with the unused bit number U (Step D431). If m is not less than U, the synthesizer 124 increments k by 1 (Step D437), and goes to Step D430. If m is less than U, the synthesizer 124 determines whether or not the decoded value E^(k) is 0 (Step D432). If the decoded value E^(k) is not 0, the synthesizer 124 increments k by 1 (Step D437), and goes to Step D430. If the decoded value E^(k) is 0, the synthesizer 124 determines whether or not the $m^{th}$ bit b(m) in the input unused bit region is 0 (Step D433). If b(m) is 0, the synthesizer 124 sets a value obtained by inverting the positive/negative of the multiplication value of the recalculated normalization value $_\tau X^=$ and a constant $C_3'$, as the value X^(k) of the decoded signal (Step D434). $C_3'$ is a constant that adjusts the magnitude of frequency components, and $C_3'$

is, for example, equal to $C_3$ or $\varepsilon \cdot C_3$. $\varepsilon$ is a variable determined in accordance with a constant or other processing. That is, the synthesizer 124 sets, as X^(k), a value defined by the following equation.

$$\hat{X}(k) = -C_3' \cdot {}_{\tau}\overline{\overline{X}} \quad \cdots (3)$$

Note that, in the processing in Step D434, only the positive/negative of X^(k) obtained in Step D424 may be modified, only the positive/negative of a value obtained by changing the amplitude of X^(k) obtained in Step D424 may be modified, and Equation (3) may be newly calculated. After Step D434, the synthesizer 124 increments each of m and k by 1 (Steps D436 and D437), and goes to Step D430.

If it is determined in Step D433 that b(m) is not 0, the synthesizer 124 sets the multiplication value of the recalculated normalization value ${}_{\tau}X^{=}$ and the constant $C_3'$, as the value X^(k) of the decoded signal (Step D435). That is, the synthesizer 124 sets, as X^(k), a value defined by the following equation.

$$\hat{X}(k) = C_3' \cdot {}_{\tau}\overline{\overline{X}} \quad \cdots (4)$$

Note that, in the processing in Step D435, only the positive/negative of X^(k) obtained in Step D424 may be modified, only the positive/negative of a value obtained by changing the amplitude of X^(k) obtained in Step D424 may be modified, and Equation (4) may be newly calculated. After Step D434, the synthesizer 124 increments each of m and k by 1 (Steps D436 and D437), and goes to Step D430 (End of Description of [Specific Example of Step D4]).

In the case where a decoded signal in a time-domain is necessary, X^(k) output from the synthesizer 124 is input to the time-domain converter 125. The time-domain converter 125 transforms X^(k) into a time-domain signal z(n) according to, for example, inverse MDCT, and outputs the resultant signal.

<Characteristics of Present Embodiment>

As described above, in the present embodiment, in the case where the decoded value E^(k) is 0, a value other than 0 is assigned to X^(k) using the recalculated normalization value ${}_{\tau}X^{=}$, and hence a spectral hole can be prevented from occurring when the input signal is, for example, a frequency-domain signal. This can reduce the musical noise and the like.

Further, in the present embodiment, the sign information is transmitted to the decoding device 12 using the unused bit region that is not used for the vector quantization by the encoding device 11. Accordingly, the decoding device 12 can identify the positive/negative of X^(k) using the sign information transmitted in the unused bit region, and hence the quality of X^(k) can be enhanced.

Note that, because the upper limit of the bit number of the sign information written into the unused bit region is the unused bit number U, the sign information corresponding to every frequency is not necessarily written into the unused bit region. In this case, the sign information is extracted in accordance with criteria defined by considering auditory perceptual characteristics, and the extracted sign information is written into the unused bit region, whereby the decoding device 12 can correctly identify the positive/negative of X^(k) at frequencies that are important in terms of, for example, the auditory perceptual characteristics. As a result, the quality of X^(k) at the frequencies that are important in terms of the auditory perceptual characteristics can be preferentially enhanced.

In addition, the positive/negative of X^(k) at frequencies at which the sign information cannot be transmitted is randomly determined using the function rand(k), and thus is not constant. Accordingly, a natural decoded signal can be made even for the frequencies at which the sign information cannot be transmitted.

[MODIFICATION OF FIRST EMBODIMENT]

As indicated by a broken line in Fig. 1, the encoding device 11 may be provided with the quantization-candidate normalization value calculator 116 that calculates a quantization-candidate normalization value ${}_{\tau}E^{-}$ that is a value representative of the quantization candidates E(k). Then, the vector quantizer 115 may collectively vector-quantize a plurality of values obtained by normalizing the quantization candidates E(k) respectively corresponding to a plurality of samples using the quantization-candidate normalization value ${}_{\tau}E^{-}$, to thereby obtain the vector quantization index. An example of the values obtained by normalizing the quantization candidates E(k) using the quantization-candidate normalization value ${}_{\tau}E^{-}$ includes a value E(k) / ${}_{\tau}E^{-}$ that is a value obtained by dividing E(k) by ${}_{\tau}E^{-}$. Because the quantization candidate E(k) is normalized and then vector-quantized, the dynamic range of the vector quantization target can be narrowed, and encoding and decoding with a smaller bit number are possible.

The quantization-candidate normalization value calculator 116 uses, for example, the quantized normalization value ${}_{\tau}X^{-}$ to calculate a value defined by the following equation, as the quantization candidate E(k) (Fig. 2 / Step E3'). $C_2$ is a positive adjustment factor (may be referred to as second constant), and is, for example, 0.3.

$${}_{\tau}\overline{E} = C_2 \cdot {}_{\tau}\overline{X}$$

In this way, because the quantization-candidate normalization value ${}_{\tau}E^{-}$ is calculated from the quantized normalization value ${}_{\tau}X^{-}$, the decoding device can calculate the quantization-candidate normalization value ${}_{\tau}E^{-}$ from the quantized normalization value ${}_{\tau}X^{-}$ without transmission of information on the quantization-candidate normalization value ${}_{\tau}E^{-}$. Accordingly, the need to transmit the information on the quantization-candidate normalization value ${}_{\tau}E^{-}$ is eliminated, and the volume of communication can be reduced.

In this case, as indicated by a broken line in Fig. 1, the decoding device 12 is provided with the decoding-candidate normalization value calculator 126. The decoding-candidate normalization value calculator 126 multiplies the decoded normalization value ${}_{\tau}X^{-}$ by the second constant $C_2$ to obtain the resultant value as a decoding-candidate normalization value ${}_{\tau}E^{-}$ (Fig. 5 / Step D2'). The decoding-candidate normalization value ${}_{\tau}E^{-}$ is sent to the vector decoder 122. Then, the vector decoder 122 inversely normalizes, using ${}_{\tau}E^{-}$, a plurality of values corresponding to the vector quantization index to obtain the resultant values as the plurality of decoded values E^(k). For example, the vector decoder 122 multiplies each of the plurality of values corresponding to the vector quantization index by the decoding-candidate normalization value ${}_{\tau}E^{-}$ to obtain the resultant values as the plurality of decoded values E^(k). Note that the decoded values E^(k) in this modification are the values obtained by inversely normalizing the plurality of values corresponding to the vector quantization index, but the quantization values E^(k) may be values before such inverse normalization.

[SECOND EMBODIMENT]

In a second embodiment, the decoding device 12 of the first embodiment or the modification thereof is replaced with a decoding device 22 (Fig. 1). In the decoding device 22, the normalization value recalculator 123 of the decoding device 12 is replaced with a normalization value recalculator 223.

In Step D3 (Fig. 5), in the case where a recalculated normalization value ${}_{\tau}X'^{=}$ calculated last time is not 0, the normalization value recalculator 223 of the second embodiment sets the weighted additional value which is the sum of the recalculated normalization value ${}_{\tau}X^{=}$ and the recalculated normalization value ${}_{\tau}X'^{=}$ calculated last time, as the recalculated normalization value ${}_{\tau}X^{=}$. In the case where the recalculated normalization value ${}_{\tau}X'^{=}$ is 0, the normalization value recalculator 223 does not necessarily need to obtain the weighted additional value which is the sum of the recalculated normalization values. That is, in the case where the recalculated normalization value ${}_{\tau}X'^{=}$ is 0, the normalization value recalculator 223 does not necessarily need to perform smoothing of the recalculated normalization values.

In the case where $C_0$ is equal to L and where the recalculated normalization value ${}_{\tau}X^{=}$ is calculated for each frame, the recalculated normalization value ${}_{\tau}X'^{=}$ calculated last time is a recalculated normalization value that is calculated for one frame before by the normalization value recalculator 223. In the case where $C_0$ is a divisor of L other than 1 and L and where the frequency components are divided into L / $C_0$ subbands and the recalculated normalization value is calculated for each subband, the recalculated normalization value ${}_{\tau}X'^{=}$ calculated last time may be a recalculated normalization value that is calculated for the same subband in one frame before, and may be a recalculated normalization value of the previous or subsequent continuous subband in the same frame for which the recalculated normalization value has already been calculated.

Assuming that a recalculated normalization value that is newly calculated this time in consideration of the recalculated normalization value ${}_{\tau}X'^{=}$ calculated last time is ${}_{\tau}X_{post}^{=}$, ${}_{\tau}X_{post}^{=}$ is expressed as in the following equation. $\alpha_1$ and $\beta$1 are adjustment factors, and are decided as appropriate in accordance with desired performance and specifications. $\alpha_1$ and $\beta_1$ are equal to, for example, 0.5.

$$\begin{cases} {}_\tau\overline{\overline{X}}_{POST} = {}_\tau\overline{\overline{X}} & \text{if} \quad {}_\tau\overline{\overline{X}}' = 0 \\ {}_\tau\overline{\overline{X}}_{POST} = \alpha_1 \cdot {}_\tau\overline{\overline{X}} + \beta_1 \cdot {}_\tau\overline{\overline{X}}' & \text{otherwise} \end{cases}$$

In this way, because the recalculated normalization value is calculated in consideration of the recalculated normalization value ${}_\tau X'^{=}$ calculated last time, values of the recalculated normalization value ${}_\tau X'^{=}$ calculated last time and the recalculated normalization value calculated this time become close to each other, and the continuity between these values is improved. Accordingly, the musical noise and the like occurring when the input signal is, for example, a frequency-domain signal can be further reduced.

[THIRD EMBODIMENT]

In a third embodiment, the decoding device 12 of the first embodiment or the modification thereof or the decoding device 22 of the second embodiment is replaced with a decoding device 32 (Fig. 1). In the decoding device 32, a smoothing unit 326 is added to the decoding device 22 or the decoding device 32.

The smoothing unit 326 receives, as its input, the value X^(k) of the decoded signal obtained in Step D4 (Fig. 5). In the case where a value X^(k)' of a past decoded signal before the value X^(k) of the decoded signal is not 0, the smoothing unit 326 outputs the weighted addition value which is the sum of the value X^(k)' of the past decoded signal and the value X^(k) of the decoded signal, as a smoothed value $X^{\wedge}_{POST}(k)$. In the case where X^(k)' is 0, the smoothing unit 326 does not obtain the weighted additional value which is the sum of the values of the decoded signals, that is, does not perform smoothing of the values of the decoded signals, and outputs X^(k) as $X^{\wedge}_{POST}(K)$ (Fig. 5 / Step D4'). Examples of the value X^(k)' of the past decoded signal include: a value of a decoded signal that is obtained in Step D4 for one frame before the frame corresponding to the value X^(k) of the decoded signal; and a smoothed value that is obtained in Step D4' for one frame before the frame corresponding to the value X^(k) of the decoded signal.

$X^{\wedge}_{POST}(K)$ is expressed as in the following equation. $\alpha_2$ and $\beta_2$ are adjustment factors, and are decided as appropriate in accordance with desired performance and specifications. $\alpha_2$ is equal to, for example, 0.85, and $\beta_2$ is equal to, for example, 0.15. $\varphi(\cdot)$ expresses the positive/negative sign of ·.

$$\begin{cases} \hat{X}_{POST}(k) = \hat{X}(k) & \text{if} \quad \hat{X}(k)' = 0 \\ \hat{X}_{POST}(k) & \\ = \{\alpha_2 \cdot |\hat{X}(k)| + \beta_2 \cdot |\hat{X}(k)'|\} \cdot \phi(\hat{X}(k)) & \text{otherwise} \end{cases}$$

This can reduce the musical noise and the like caused by the discontinuity in the time axis direction of amplitude characteristics of X^(k). In the case where a decoded signal in a time-domain is necessary, $X^{\wedge}_{POST}(k)$ output from the smoothing unit 326 is input to the time-domain converter 125. The time-domain converter 125 transforms $X^{\wedge}_{POST}(k)$ into the time-domain signal z(n) according to, for example, inverse MDCT, and outputs the resultant signal.

[FOURTH EMBODIMENT]

In a fourth embodiment, the decoding device 12, 22, or 32 of each embodiment described above or the modification thereof is replaced with a decoding device 42 (Fig. 1). In the decoding device 42, the normalization value recalculator 123 or 223 and the synthesizer 124 are replaced with a synthesizer 424 having functions of both the units.

In the present embodiment, the synthesizer 424 receives, as its inputs, ${}_\tau X^{-}$, b(m), E^(k), and U, and performs processing illustrated in Fig. 9, Fig. 10, and Fig. 11 in place of the specific examples of Steps D3 and D4 described above. Note that the following processing is executed for each $\tau$ described above. That is, in the case where $C_0$ is L, the following processing is executed for each frame. In the case where $C_0$ is a common divisor of L other than 1 and L, the following processing is repeatedly executed for each subband in one frame.

The synthesizer 424 sets $\tau \cdot C_0$ to k, sets 0 to m, and sets 0 to tmp, to thereby initialize these values k, m, and tmp (Step D311).
The synthesizer 424 compares k with $(\tau + 1) \cdot C_0$ (Step D312). If k is less than $(\tau + 1) \cdot C_0$, the synthesizer 424 determines whether or not the decoded value E^(k) is 0 (Step D313). If the decoded value E^(k) is 0, the synthesizer 424 increments k by 1 (Step D317), and goes to Step D312. If the decoded value E^(k) is not 0, the synthesizer 424 calculates the power of the sample of the identification number k, and adds the calculated power to tmp (Step D314). That is, the synthesizer 424 sets a value obtained by adding the calculated power to a value of tmp, as a new value of tmp. For example, the synthesizer 424 calculates the power according to the following equation.
$$\left(C_1 \cdot {}_{\tau}\overline{X} + |\hat{E}(k)|\right)^2$$

Further, the synthesizer 424 increments m by 1 (Step D315), and calculates the following equation (Step D316).
$$\hat{X}(k) = \mathrm{SIGN}(\hat{E}(k)) \cdot \left(C_1 \cdot {}_{\tau}\overline{X} + |\hat{E}(k)|\right)$$

Note that SIGN(E^(k)) is a function that is 1 when E^(k) is positive and is -1 when E^(k) is negative. After that, the synthesizer 424 increments m by 1 (Step D317), and goes to Step D312.
If it is determined in Step D312 that k is not less than $(\tau + 1) \cdot C_0$, the synthesizer 424 calculates a value of ${}_{\tau}X^{=}$ defined by the following equation (Step D318).
$${}_{\tau}\overline{\overline{X}} = \sqrt{\frac{C_0 \cdot {}_{\tau}\overline{X}^2 - \mathrm{tmp}}{C_0 - m}}$$

Further, the synthesizer 424 sets $\tau \cdot C_0$ to k, to thereby initialize a value of k (Step D321).
The synthesizer 424 compares k with $(\tau + 1) \cdot C_0$ (Step D322). If k is not less than $(\tau + 1) \cdot C_0$, the synthesizer 424 goes to Step D429 in Fig. 9 described above. If k is less than $(\tau + 1) \cdot C_0$, the synthesizer 424 determines whether or not the decoded value E^(k) is 0 (Step D323). If the decoded value E^(k) is 0, the synthesizer 424 sets a value obtained by randomly inverting the positive/negative of the multiplication value of the recalculated normalization value ${}_{\tau}X^{=}$ and the first constant $C_3$, as the value X^(k) of the decoded signal (Step D324). That is, the synthesizer 424 calculates, as X^(k), a value defined by the following equation. In this way, the synthesizer 424 sets, as X^(k), a value having, as an absolute value, the value obtained by multiplying the recalculated normalization value ${}_{\tau}X^{=}$ by the first constant $C_3$.
$$\hat{X}(k) = C_3 \cdot {}_{\tau}\overline{\overline{X}} \cdot \mathrm{rand}(k)$$

After that, the synthesizer 424 increments k by 1 (Step D328), and goes to Step D322.
On the other hand, if it is determined in Step D323 that the decoded value E^(k) is not 0, the synthesizer 424 increments k by 1 (Step D328) without updating X^(k), and goes to Step D322.

[OTHER MODIFICATIONS]

Note that the present invention is not limited to the above-mentioned embodiments. For example,$C_0$, $C_1$, $C_2$, $C_3$, $\alpha_1$, $\beta_1$, $\alpha_2$, and $\beta_2$ may be changed as appropriate in accordance with desired performance and specifications. In addition, the input signal X(k) does not necessarily need to be a frequency-domain signal, and may be a given signal such as a time-domain signal. That is, the present invention can be applied to encoding and decoding of a given signal other than a frequency-domain signal.

In addition, a normalization value $F_{GAIN}$ for the input signal X(k) may be determined for each frame, and the quantization-candidate calculator 114 may use a value obtained by normalizing X(k) using the normalization value $F_{GAIN}$ in place of the value X(k) of each sample of the input signal, and may use a value obtained by normalizing ${}_{\tau}X^{-}$ using the normalization value $F_{GAIN}$ in place of the quantized normalization value ${}_{\tau}X^{-}$, to thereby execute the processing of Step E3. For example, the processing of Step E3 may be executed in the state where X(k) is replaced with X(k) / $F_{GAIN}$ and where ${}_{\tau}X^{-}$ is replaced with ${}_{\tau}X^{-}$ / $F_{GAIN}$. In addition, in this case, the normalization value calculator 112 does not exist, and the value obtained by normalizing X(k) using the normalization value $F_{GAIN}$ may be input to the normalization value quantizer 113, in place of the quantized normalization value ${}_{\tau}X^{-}$. In this case, the quantization-candidate calculator 114 may use a quantization value of the value obtained by normalizing X(k) using the normalization value $F_{GAIN}$ in place of the quantized normalization value ${}_{\tau}X^{-}$, to thereby perform the processing of Step E3. The normalization-value quantization index may correspond to the quantization value of the value obtained by normalizing X(k) using the normalization value $F_{GAIN}$.

In addition, the various processes described above may be chronologically executed in the described order, and may be executed in parallel or individually as needed or in accordance with the processing capacity of an apparatus that executes the processes. Moreover, it goes without saying that the present invention can be changed as appropriate within the range not departing from the gist thereof.

[HARDWARE, PROGRAM, AND RECORDING MEDIUM]

The above-mentioned encoding device 11 and decoding devices 12, 22, and 33 each include, for example: a publicly known or dedicated computer formed of a central processing unit (CPU), a random-access memory (RAM), and the like; and a special program in which the above-mentioned processing contents are written. In this case, the special program is read by the CPU, and the CPU executes the special program to thereby implement each function. In addition, the special program may be formed of a single program sequence, and may implement a desired function by reading another program or a library.

Such a program can be recorded in a computer-readable recording medium. Examples of the computer-readable recording medium include a magnetic recording apparatus, an optical disk, a magneto-optical recording medium, and a semiconductor memory. The program is distributed by, for example, selling, assigning, leasing, and the like a portable recording medium such as a DVD or a CD-ROM that records therein the program. Alternatively, the program may be stored in a storage device of a server computer and be transferred for distribution from the server computer to another computer via a network.

A computer that executes such a program, for example, first temporarily stores the program recorded in the portable recording medium or the program transferred from the server computer, into its own storage device. Then, at the time of execution of processing, the computer reads the program stored in its own recording medium, and executes the processing according to the read program. Alternatively, according to another execution mode of the program, the computer may read the program directly from the portable recording medium to execute the processing according to the program. Still alternatively, each time the program is transferred from the server computer to the computer, the computer may sequentially execute the processing according to the received program.

In addition, at least part of the processing parts of the encoding device 11 and the decoding device 12, 22, or 33 may be formed of a special integrated circuit.

[DESCRIPTION OF REFERENCE NUMERALS]

| | |
|---|---|
| 11: | encoding device |
| 111: | frequency-domain converter |
| 112: | normalization value calculator |
| 113: | normalization value quantizer |
| 114: | quantization-candidate calculator |
| 115: | vector quantizer |

| | |
|---|---|
| 116: | quantization-candidate normalization value calculator |
| 117: | sign information output unit |
| 12: | decoding device |
| 121: | normalization value decoder |
| 122: | vector decoder |
| 123, 223: | normalization value recalculator |
| 124: | synthesizer |
| 125: | time-domain converter |
| 126: | decoding-candidate normalization value calculator |
| 326: | smoothing unit |

## Claims

**1.** An encoding method comprising:

a normalization value quantizing step of obtaining: a quantized normalization value by quantizing a normalization value that is a value representative of a predetermined number of samples; and a normalization-value quantization index corresponding to the quantized normalization value;
a quantization-candidate step of: setting, if a difference value that is obtained by subtracting a value corresponding to the quantized normalization value from a value corresponding to a magnitude of a value of each sample is positive and if the value of each sample is positive, the difference value as a quantization candidate corresponding to each sample; and setting, if the difference value is positive and if the value of each sample is negative, a value obtained by inverting positive/negative of the difference value, as the quantization candidate corresponding to each sample;
a vector quantizing step of vector-quantizing the quantization candidate to obtain and output a vector quantization index; and
a sign information output step of outputting sign information that expresses positive/negative of at least one sample that does not make the difference value positive, among the samples.

**2.** The encoding method according to claim 1, wherein
the value corresponding to the magnitude of the value of the sample is an absolute value of the value of the sample, and the value corresponding to the quantized normalization value is a product of the quantized normalization value and an adjustment constant $C_1$ having a predetermined positive value.

**3.** The encoding method according to claim 1 or 2, wherein
the quantization-candidate step further includes a process of setting, if the difference value is not positive, 0 as the quantization candidate corresponding to each sample.

**4.** The encoding method according to any of claims 1 to 3, wherein
the sign information output step includes outputting only the sign information corresponding to a sample that is selected according to a criterion based on an auditory characteristic from among the samples that do not make the difference value positive.

**5.** The encoding method according to any of claims 1 to 3, wherein
the sign information output step includes: selecting a predetermined number of samples in order from a sample corresponding to a lower frequency from among the samples that do not make the difference value positive; and outputting the sign information corresponding to the selected sample(s).

**6.** The encoding method according to any of claims 1 to 5, further comprising a quantization-candidate normalization value calculating step of calculating a quantization-candidate normalization value that is a value representative of the quantization candidates, wherein
the vector quantizing step includes: normalizing the quantization candidates respectively corresponding to the plurality of samples using the quantization-candidate normalization value; and collectively vector-quantizing the plurality of resultant values, to thereby obtain the vector quantization index.

**7.** The encoding method according to claim 6, wherein
the quantization-candidate normalization value is a product of the quantized normalization value and a predetermined

adjustment constant $C_2$.

**8.** A decoding method comprising:

a normalization value decoding step of obtaining a decoded normalization value corresponding to an input normalization-value quantization index;
a vector decoding step of obtaining a plurality of values corresponding to an input vector quantization index, as a plurality of decoded values; and
a synthesizing step of: using a recalculated normalization value having a value that becomes smaller as a sum of absolute values of a predetermined number of the decoded values is larger; setting, if each decoded value is 0 and if sign information corresponding to the decoded value is input, a value obtained by giving positive/negative expressed by the sign information to a product of the recalculated normalization value and a first constant, as a decoded signal; setting, if each decoded value is 0 and if the sign information corresponding to the decoded value is not input, a value having, as an absolute value, a value obtained by multiplying the recalculated normalization value by the first constant, as the decoded signal; and setting, if each decoded value is not 0, a value obtained by reflecting positive/negative of each decoded value in a linear sum of each decoded value or the absolute value of each decoded value and the decoded normalization value, as the decoded signal.

**9.** The decoding method according to claim 8, wherein
the value having, as the absolute value, the value obtained by multiplying the recalculated normalization value by the first constant is a value obtained by randomly inverting positive/negative of the value obtained by multiplying the recalculated normalization value by the first constant.

**10.** The decoding method according to claim 8 or 9, further comprising a normalization value recalculating step of calculating, as the recalculated normalization value, $X^{=}$ defined by the following equation assuming that: $C_0$ is the predetermined number; $X^{-}$ is the decoded normalization value; tmp is a sum of squares of a linear sum of absolute values of decoded values and the decoded normalization value, the decoded values not being 0 among the predetermined number of decoded values; and m is the number of decoded values that are 0 among the predetermined number of decoded values,

$$\overline{\overline{X}} = \sqrt{\frac{C_0 \overline{X}^2 - tmp}{m}} .$$

**11.** The decoding method according to any of claims 8 to 10, wherein
the synthesizing step includes, if each decoded value is not 0: adding the absolute value of each decoded value to a value obtained by multiplying the decoded normalization value by an adjustment constant $C_1$ having a predetermined positive value; multiplying the resultant value by the positive/negative of each decoded value; and setting the resultant value as the decoded signal.

**12.** The decoding method according to any of claims 8 to 11, wherein
the normalization value recalculating step includes, if the recalculated normalization value is not 0, setting a weighted additional value which is the sum of the recalculated normalization value and a recalculated normalization value calculated last time, as the recalculated normalization value.

**13.** The decoding method according to any of claims 8 to 12, further comprising a smoothing step of setting, if a value of a past decoded signal is not 0, a value obtained by reflecting positive/negative of a value of the decoded signal in a weighted additional value of an absolute value of the past decoded signal and an absolute value of the decoded signal, as the value of the decoded signal.

**14.** The decoding method according to any of claims 8 to 13, further comprising a decoding-candidate normalization value calculating step of setting a multiplication value of the decoded normalization value and a second constant, as a decoding-candidate normalization value, wherein
the vector decoding step includes setting multiplication values of the respective plurality of values corresponding to the vector quantization index and the decoding-candidate normalization value, as the plurality of decoded values.

**15.** An encoding device comprising:

a normalization value quantizer that obtains: a quantized normalization value by quantizing a normalization value that is a value representative of a predetermined number of samples; and a normalization-value quantization index corresponding to the quantized normalization value;
a quantization-candidatequantization-candidate calculator that sets, if a difference value that is obtained by subtracting a value corresponding to the quantized normalization value from a value corresponding to a magnitude of a value of each sample is positive and if the value of each sample is positive, the difference value as a quantization candidate corresponding to each sample; and sets, if the difference value is positive and if the value of each sample is negative, a value obtained by inverting positive/negative of the difference value, as the quantization candidate corresponding to each sample;
a vector quantizer that vector-quantizes the quantization candidate to obtain and output a vector quantization index; and
a sign information output unit that outputs sign information that expresses positive/negative of at least one sample that does not make the difference value positive, among the samples.

**16.** The encoding device according to claim 15, wherein
the value corresponding to the magnitude of the value of the sample is an absolute value of the value of the sample, and the value corresponding to the quantized normalization value is a product of the quantized normalization value and an adjustment constant $C_1$ having a predetermined positive value.

**17.** The encoding device according to claim 15 or 16, wherein
the quantization-candidate calculator further performs a process of setting, if the difference value is not positive, 0 as the quantization candidate corresponding to each sample.

**18.** The encoding device according to any of claims 15 to 17, wherein
the sign information output unit outputs only the sign information corresponding to a sample that is selected according to a criterion based on an auditory characteristic from among the samples that do not make the difference value positive.

**19.** The encoding device according to any of claims 15 to 17, wherein
the sign information output unit selects a predetermined number of samples in order from a sample corresponding to a lower frequency from among the samples that do not make the difference value positive, and outputs the sign information corresponding to the selected sample(s).

**20.** The encoding device according to any of claims 15 to 19, further comprising a quantization-candidate normalization value calculator that calculates a quantization-candidate normalization value that is a value representative of the quantization candidates, wherein
the vector quantizer normalizes the quantization candidates respectively corresponding to the plurality of samples using the quantization-candidate normalization value, and collectively vector-quantizes the plurality of resultant values, to thereby obtain the vector quantization index.

**21.** The encoding device according to claim 20, wherein
the quantization-candidate normalization value is a product of the quantized normalization value and a predetermined adjustment constant $C_2$.

**22.** A decoding device comprising:

a normalization value decoder that obtains a decoded normalization value corresponding to an input normalization-value quantization index;
a vector decoder that obtains a plurality of values corresponding to an input vector quantization index, as a plurality of decoded values; and
a synthesizer that uses a recalculated normalization value having a value that becomes smaller as a sum of absolute values of a predetermined number of the decoded values is larger; sets, if each decoded value is 0 and if sign information corresponding to the decoded value is input, a value obtained by giving positive/negative expressed by the sign information to a product of the recalculated normalization value and a first constant, as a decoded signal; sets, if each decoded value is 0 and if the sign information corresponding to the decoded value is not input, a value having, as an absolute value, a value obtained by multiplying the recalculated normalization value by the first constant, as the decoded signal; and sets, if each decoded value is not 0, a value obtained by reflecting positive/negative of each decoded value in a linear sum of each decoded value or the absolute value of each decoded value and the decoded normalization value, as the decoded signal.

**23.** The decoding device according to claim 22, wherein
the value having, as the absolute value, the value obtained by multiplying the recalculated normalization value by the first constant is a value obtained by randomly inverting positive/negative of the value obtained by multiplying the recalculated normalization value by the first constant.

**24.** The decoding device according to claim 22 or 23, further comprising a normalization value recalculator that calculates, as the recalculated normalization value, $X^{=}$ defined by the following equation assuming that: $C_0$ is the predetermined number; $X^{-}$ is the decoded normalization value; tmp is a sum of squares of a linear sum of absolute values of decoded values and the decoded normalization value, the decoded values not being 0 among the predetermined number of decoded values; and m is the number of decoded values that are 0 among the predetermined number of decoded values,

$$\overline{\overline{X}} = \sqrt{\frac{C_0 \overline{X}^2 - tmp}{m}} .$$

**25.** The decoding device according to any of claims 22 to 24, wherein
if each decoded value is not 0, the synthesizer adds the absolute value of each decoded value to a value obtained by multiplying the decoded normalization value by an adjustment constant $C_1$ having a predetermined positive value; multiplies the resultant value by the positive/negative of each decoded value; and sets the resultant value as the decoded signal.

**26.** The decoding device according to any of claims 22 to 25, wherein
if the recalculated normalization value is not 0, the normalization value recalculator sets a weighted additional value which is the sum of the recalculated normalization value and a recalculated normalization value calculated last time, as the recalculated normalization value.

**27.** The decoding device according to any of claims 22 to 26, further comprising a smoothing unit that sets, if a value of a past decoded signal is not 0, a value obtained by reflecting positive/negative of a value of the decoded signal in a weighted additional value which is the sum of an absolute value of the past decoded signal and an absolute value of the decoded signal, as the value of the decoded signal.

**28.** The decoding device according to any of claims 22 to 27, further comprising a decoding-candidate normalization value calculator that sets a multiplication value of the decoded normalization value and a second constant, as a decoding-candidate normalization value, wherein
the vector decoder sets multiplication values of the respective plurality of values corresponding to the vector quantization index and the decoding-candidate normalization value, as the plurality of decoded values.

**29.** A program for causing a computer to execute the respective steps in the method according to any of claims 1 to 14.

**30.** A computer-readable recording medium comprising, recorded therein, the program according to claim 29.

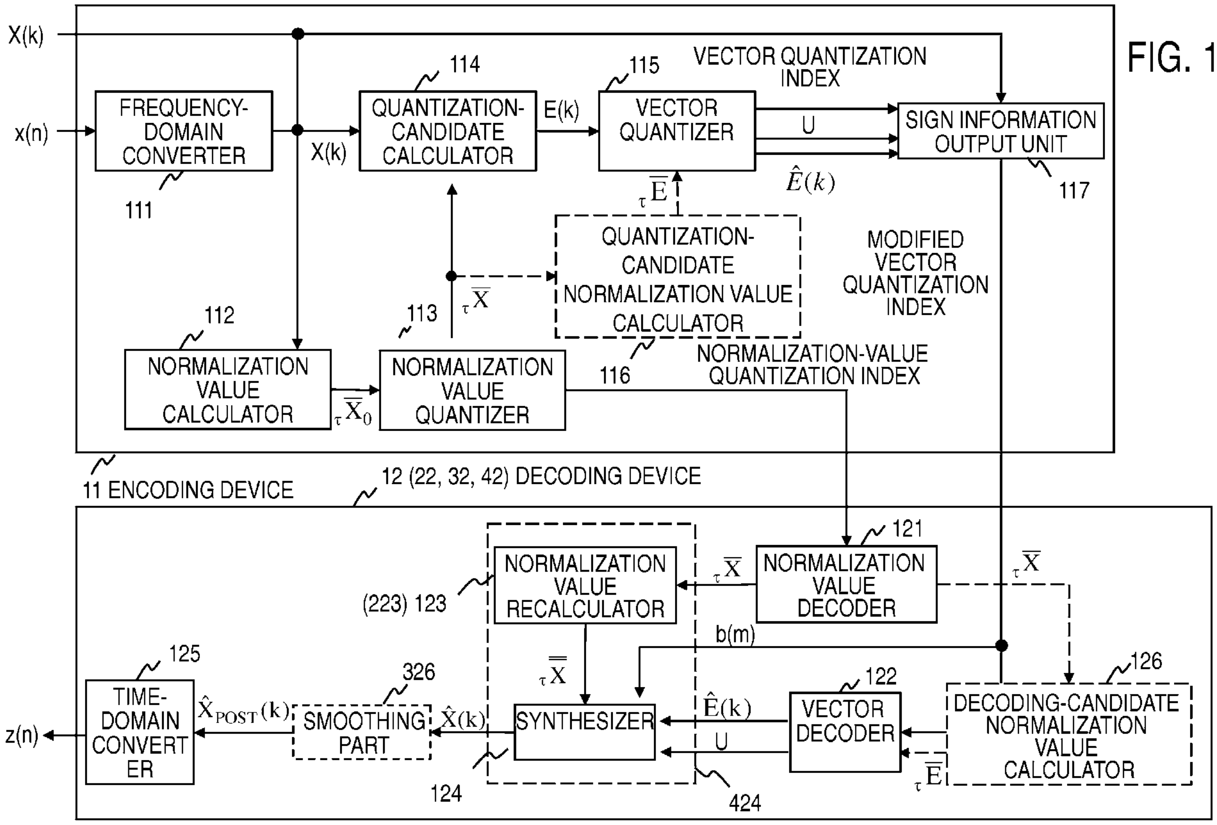
X(k)
x(n)
FREQUENCY-DOMAIN CONVERTER
111
X(k)
114
QUANTIZATION-CANDIDATE CALCULATOR
E(k)
115
VECTOR QUANTIZER
VECTOR QUANTIZATION INDEX
U
SIGN INFORMATION OUTPUT UNIT
117
Ê(k)
τĒ
QUANTIZATION-CANDIDATE NORMALIZATION VALUE CALCULATOR
MODIFIED VECTOR QUANTIZATION INDEX
τX̄
112
NORMALIZATION VALUE CALCULATOR
113
NORMALIZATION VALUE QUANTIZER
τX̄0
116
NORMALIZATION-VALUE QUANTIZATION INDEX
11 ENCODING DEVICE
12 (22, 32, 42) DECODING DEVICE
121
NORMALIZATION VALUE DECODER
τX̄
NORMALIZATION VALUE RECALCULATOR
(223) 123
b(m)
125
TIME-DOMAIN CONVERTER
326
SMOOTHING PART
X̂POST(k)
X̂(k)
SYNTHESIZER
Ê(k)
U
122
VECTOR DECODER
126
DECODING-CANDIDATE NORMALIZATION VALUE CALCULATOR
τĒ
z(n)
124
424

FIG. 1

FIG. 2

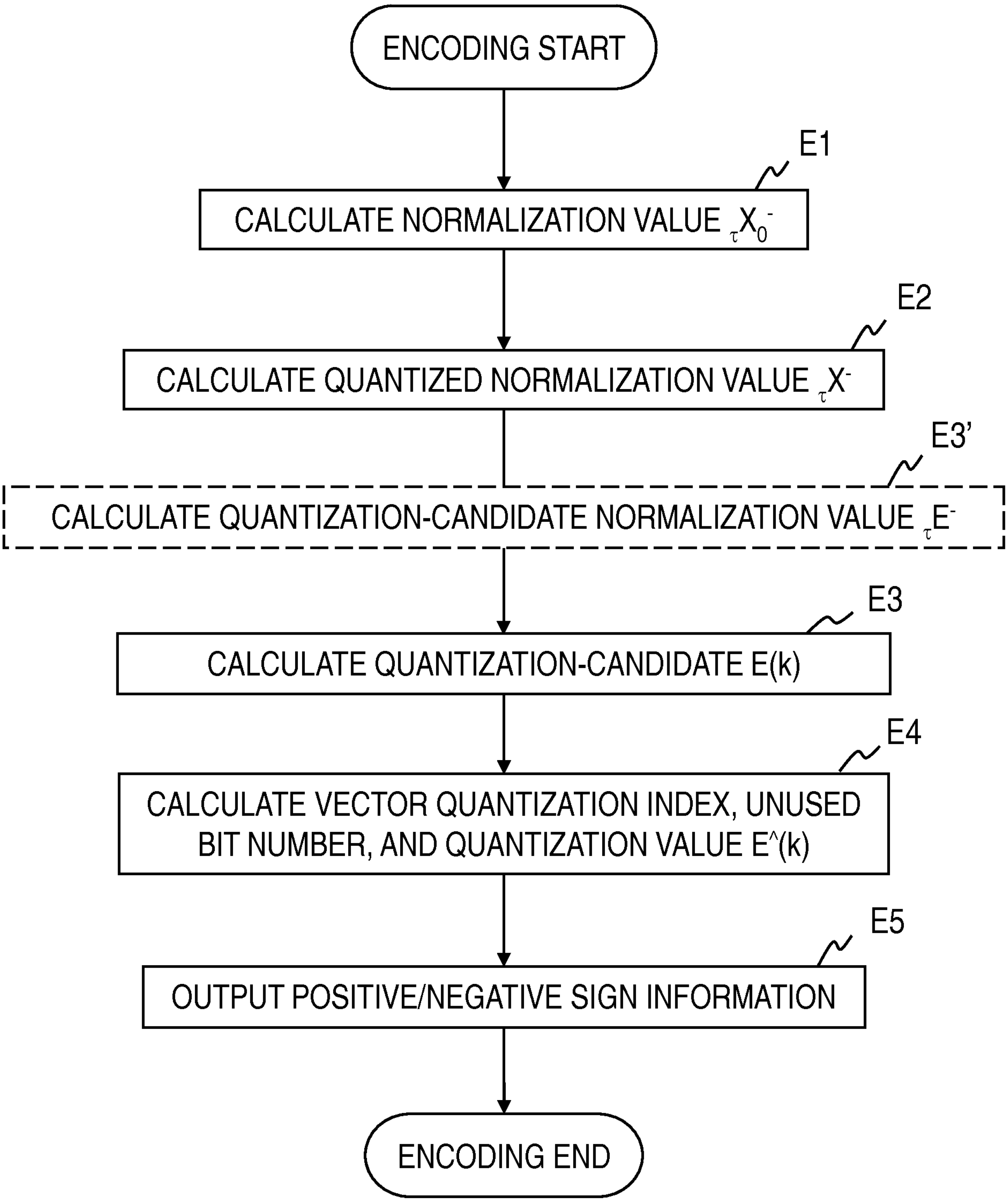
ENCODING START
E1
CALCULATE NORMALIZATION VALUE $_{\tau}X_0^-$
E2
CALCULATE QUANTIZED NORMALIZATION VALUE $_{\tau}X^-$
E3'
CALCULATE QUANTIZATION-CANDIDATE NORMALIZATION VALUE $_{\tau}E^-$
E3
CALCULATE QUANTIZATION-CANDIDATE E(k)
E4
CALCULATE VECTOR QUANTIZATION INDEX, UNUSED BIT NUMBER, AND QUANTIZATION VALUE E^(k)
E5
OUTPUT POSITIVE/NEGATIVE SIGN INFORMATION
ENCODING END

FIG. 3

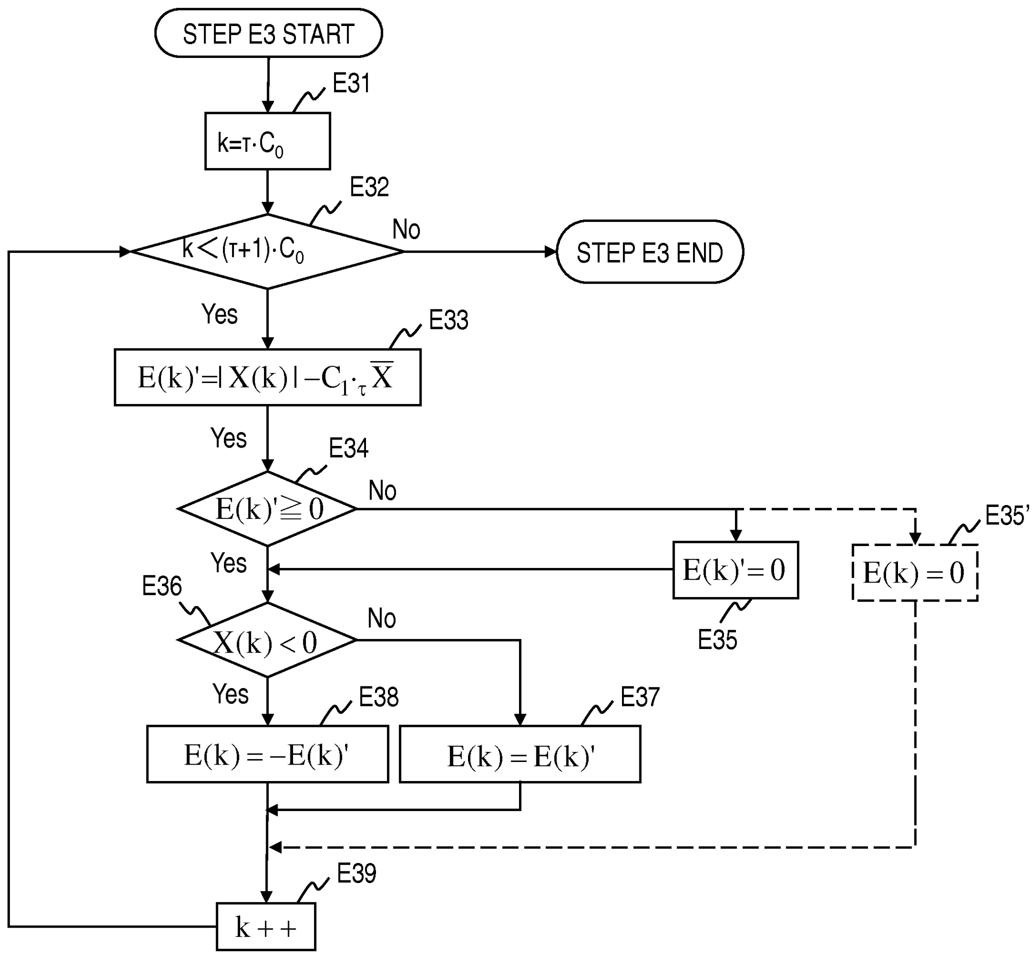
STEP E3 START
E31
k=τ·C0
E32
k<(τ+1)·C0
No
STEP E3 END
Yes
E33
E(k)'=|X(k)|−C1·τX
Yes
E34
E(k)'≧0
No
E35'
E(k)'=0
E(k)=0
Yes
E35
E36
X(k)<0
No
Yes
E38
E37
E(k)=−E(k)'
E(k)=E(k)'
E39
k++

FIG. 4

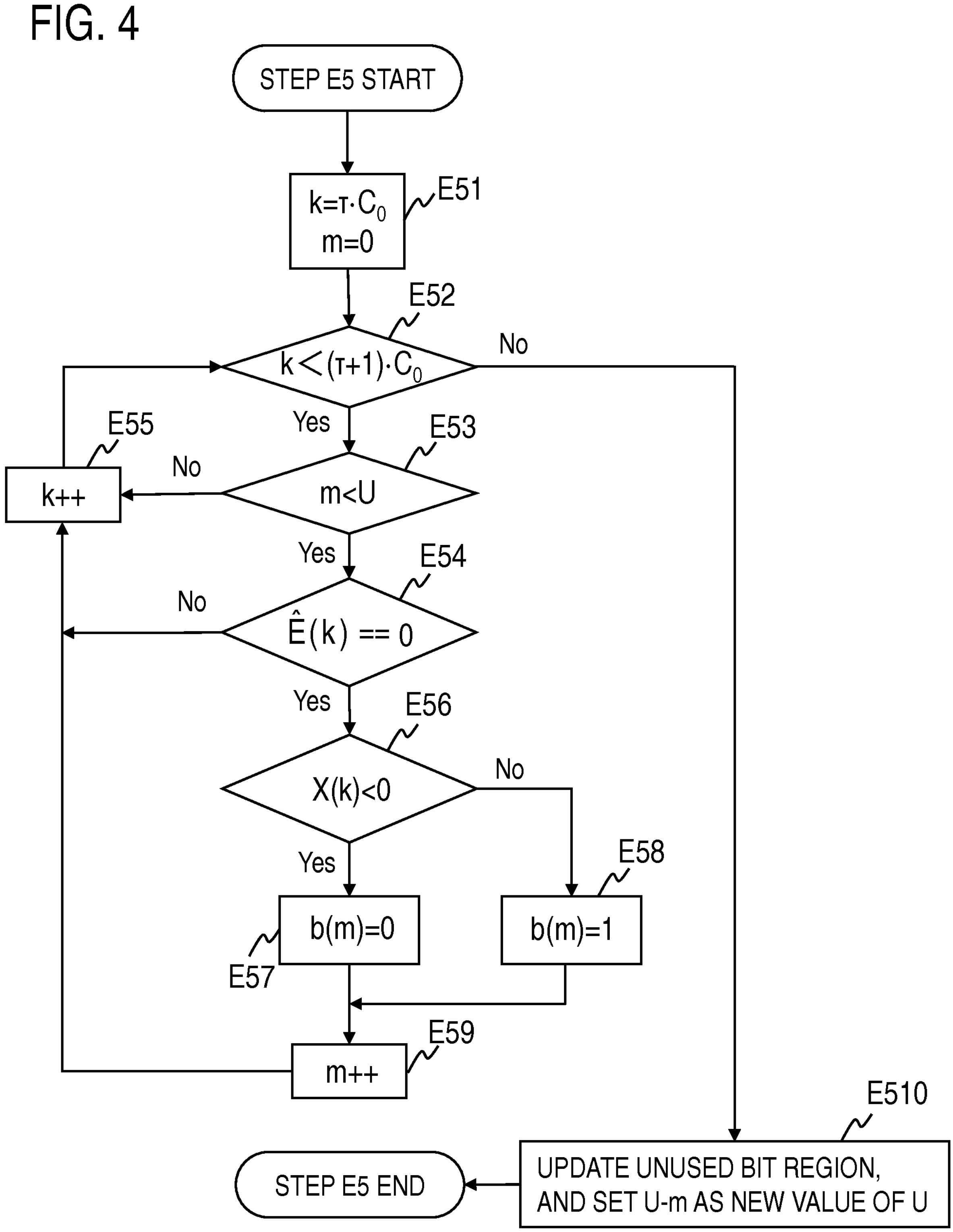
STEP E5 START
k=τ·$C_0$
m=0
E51
E52
k<(τ+1)·$C_0$
No
Yes
E53
m<U
No
E55
k++
Yes
E54
Ê(k) == 0
No
Yes
E56
X(k)<0
No
Yes
E58
b(m)=0
b(m)=1
E57
E59
m++
E510
STEP E5 END
UPDATE UNUSED BIT REGION, AND SET U-m AS NEW VALUE OF U

FIG. 5

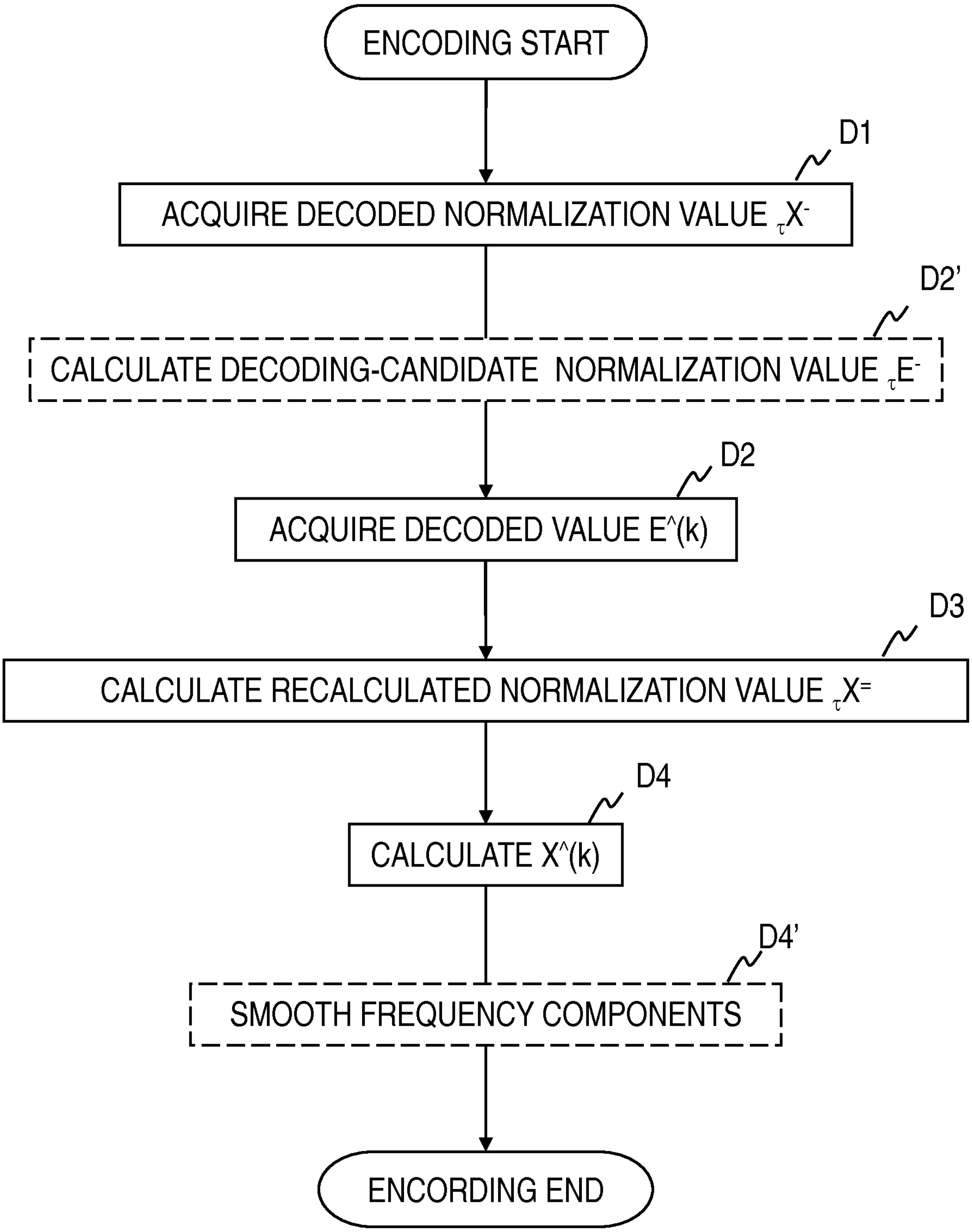
ENCODING START
D1
ACQUIRE DECODED NORMALIZATION VALUE τX-
D2'
CALCULATE DECODING-CANDIDATE NORMALIZATION VALUE τE-
D2
ACQUIRE DECODED VALUE E^(k)
D3
CALCULATE RECALCULATED NORMALIZATION VALUE τX=
D4
CALCULATE X^(k)
D4'
SMOOTH FREQUENCY COMPONENTS
ENCORDING END

FIG. 6

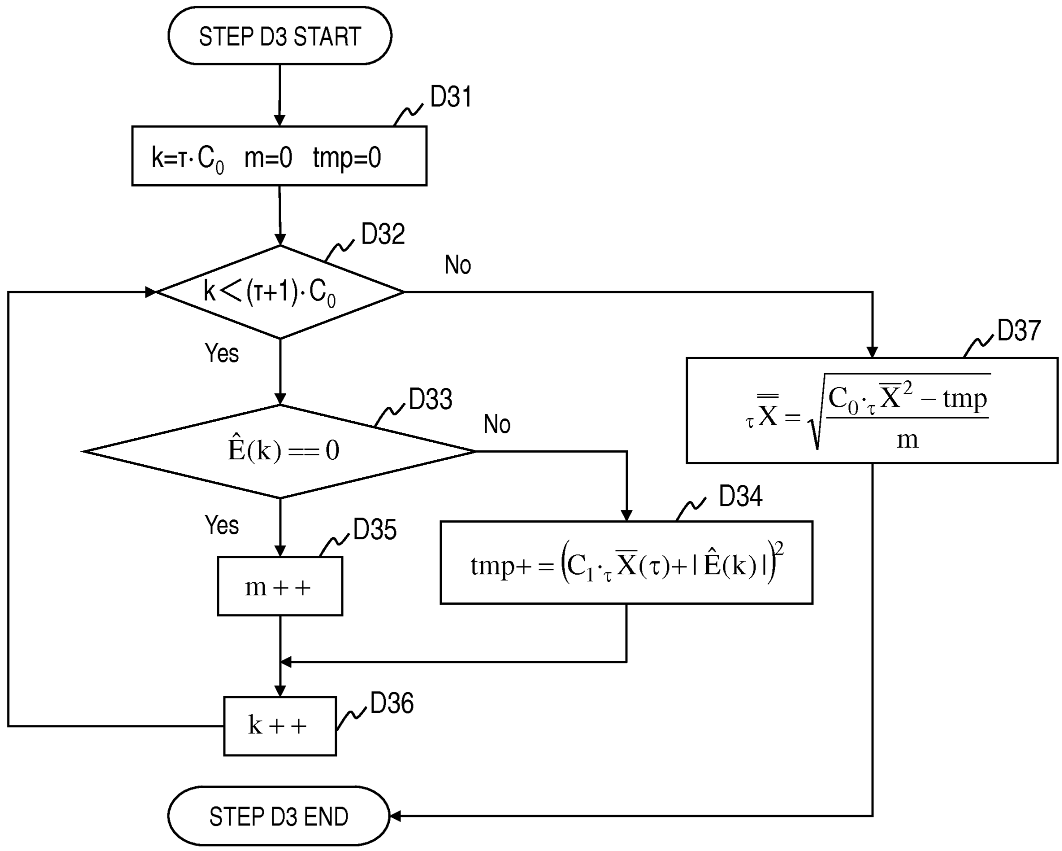
STEP D3 START
D31
k=τ·C0 m=0 tmp=0
D32
k<(τ+1)·C0
No
Yes
D33
Ê(k) == 0
No
Yes
D34
tmp+ = (C1·τX̄(τ)+|Ê(k)|)^2
D35
m++
D36
k++
D37
τX̿ = √((C0·τX̄^2 − tmp)/m)
STEP D3 END

FIG. 7

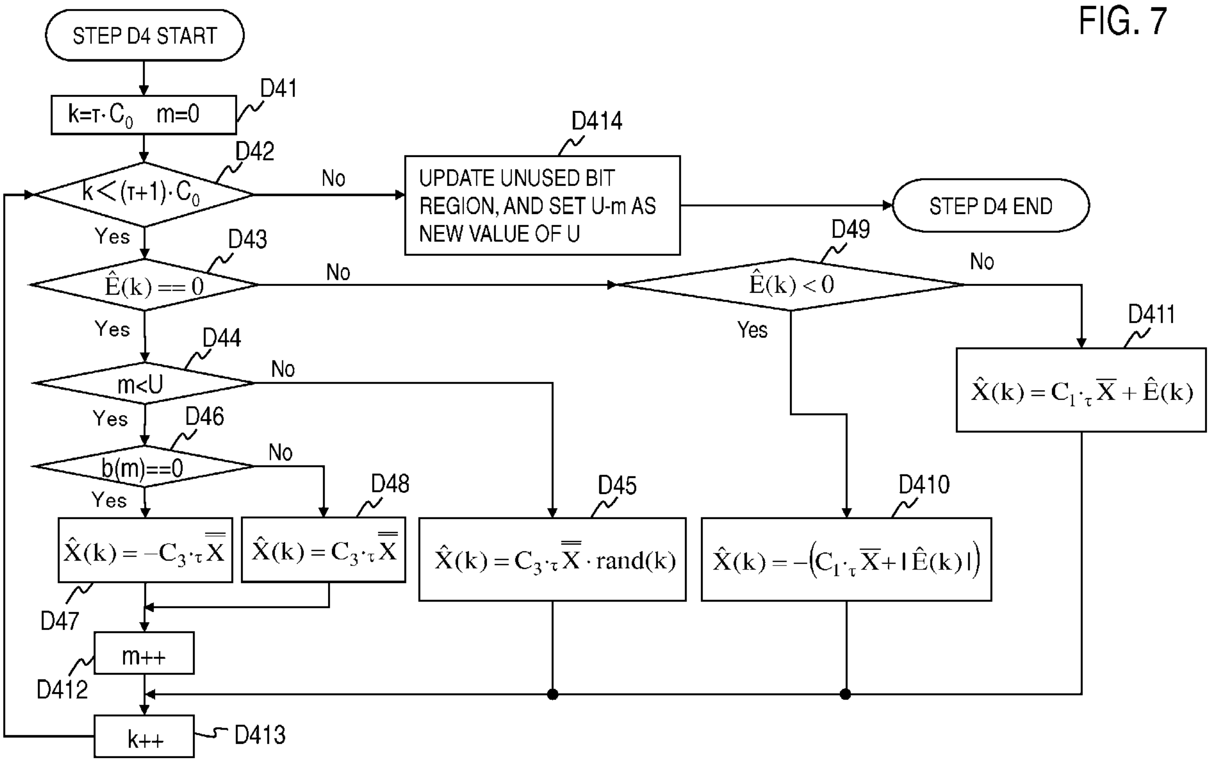
STEP D4 START
D41
k=τ·$C_0$ m=0
D42
k<(τ+1)·$C_0$
No
D414
UPDATE UNUSED BIT REGION, AND SET U-m AS NEW VALUE OF U
STEP D4 END
Yes
D43
$\hat{E}(k) == 0$
No
D49
$\hat{E}(k) < 0$
No
D411
Yes
$\hat{X}(k) = C_1 \cdot_\tau \overline{X} + \hat{E}(k)$
Yes
D44
m<U
No
Yes
D46
b(m)==0
No
Yes
D48
D45
D410
$\hat{X}(k) = -C_3 \cdot_\tau \overline{\overline{X}}$
$\hat{X}(k) = C_3 \cdot_\tau \overline{\overline{X}}$
$\hat{X}(k) = C_3 \cdot_\tau \overline{\overline{X}} \cdot \mathrm{rand}(k)$
$\hat{X}(k) = -(C_1 \cdot_\tau \overline{X} + |\hat{E}(k)|)$
D47
m++
D412
k++
D413

FIG. 8

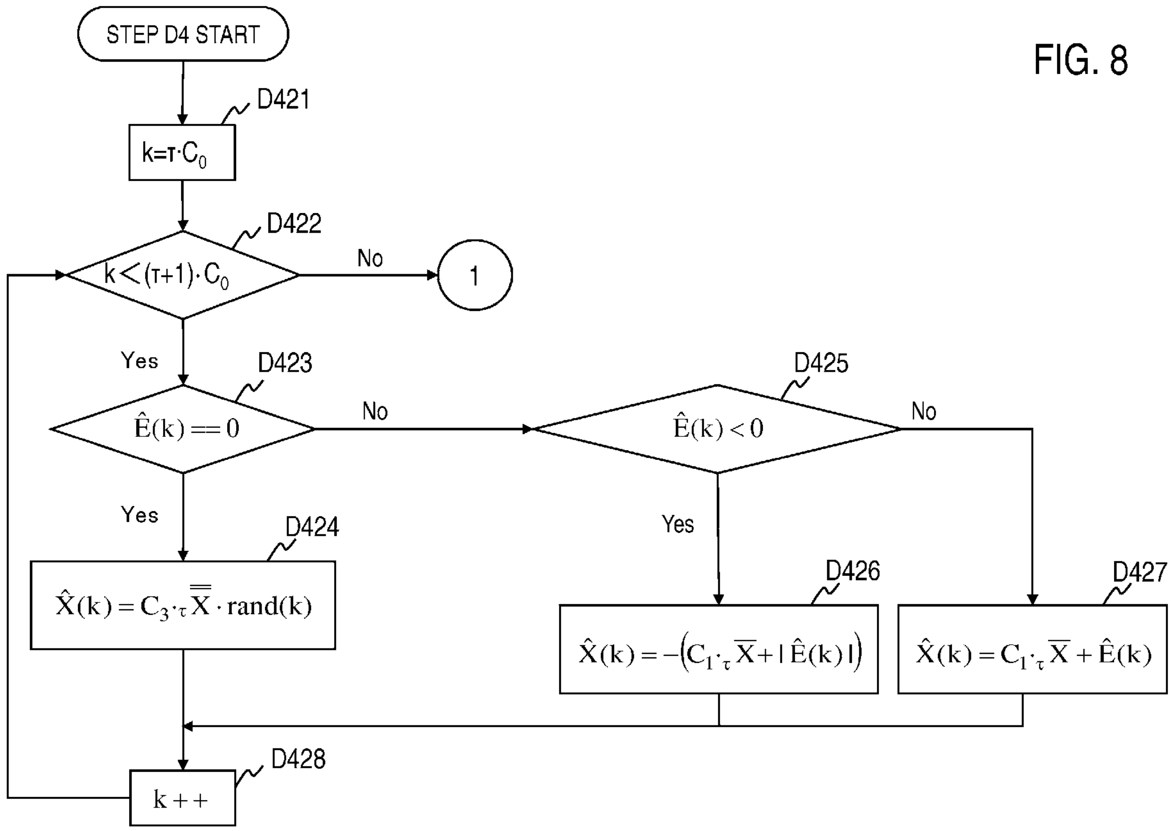
STEP D4 START
D421
k=τ·C0
D422
k<(τ+1)·C0
No
1
Yes
D423
Ê(k) == 0
No
D425
Ê(k) < 0
No
Yes
D424
X̂(k) = C3·τX̿ · rand(k)
Yes
D426
X̂(k) = −(C1·τX̄ + | Ê(k) |)
D427
X̂(k) = C1·τX̄ + Ê(k)
D428
k++

FIG. 9

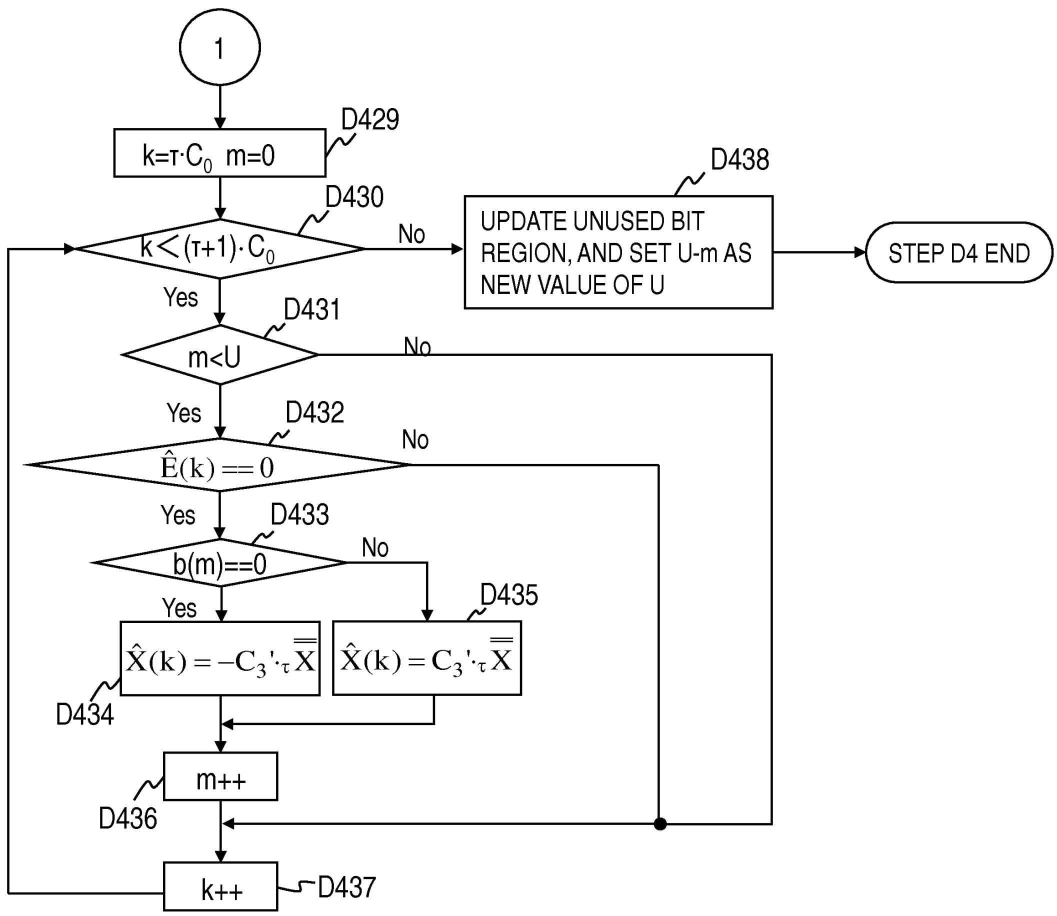
1
D429
k=τ·C0 m=0
D430
k<(τ+1)·C0
No
D438
UPDATE UNUSED BIT REGION, AND SET U-m AS NEW VALUE OF U
STEP D4 END
Yes
D431
m<U
No
Yes
D432
Ê(k) == 0
No
Yes
D433
b(m)==0
No
Yes
D435
X̂(k) = −C3'·τ X̿
X̂(k) = C3'·τ X̿
D434
m++
D436
k++
D437

FIG. 10

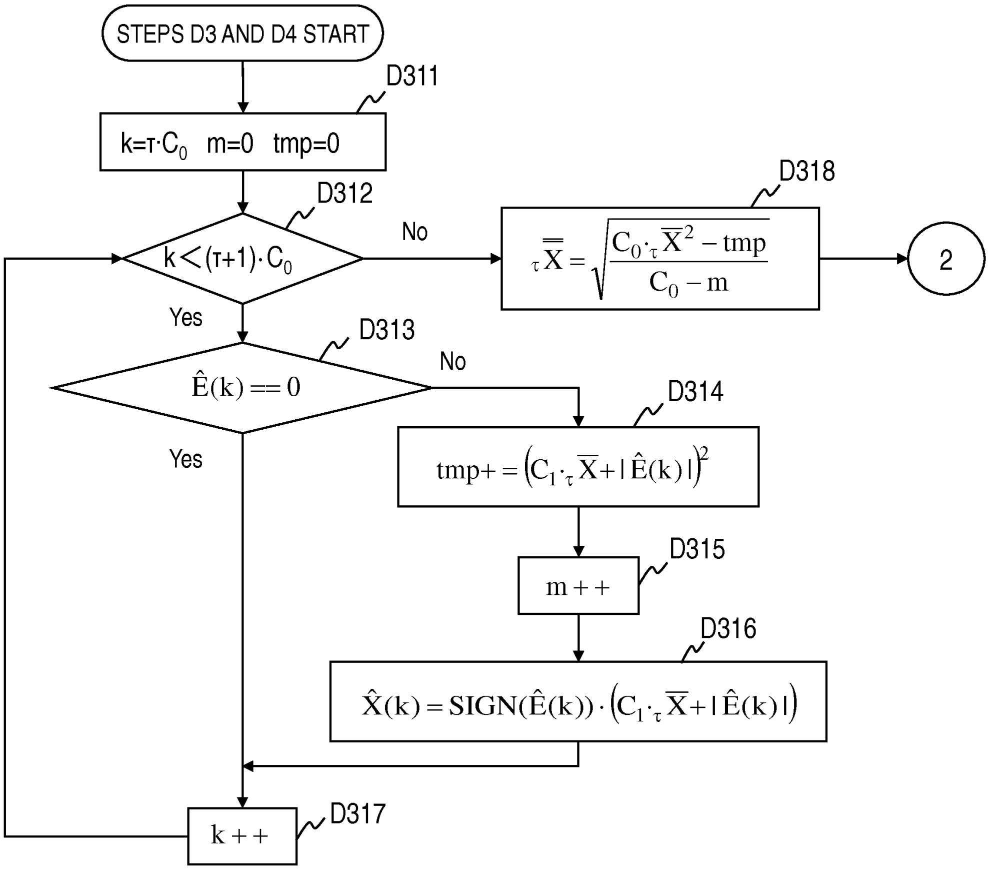
STEPS D3 AND D4 START
D311
k=τ·C0 m=0 tmp=0
D312
k<(τ+1)·C0
No
D318
$_{\tau}\overline{\overline{X}} = \sqrt{\frac{C_0 \cdot {}_{\tau}\overline{X}^2 - tmp}{C_0 - m}}$
2
Yes
D313
$\hat{E}(k) == 0$
No
D314
$tmp+=(C_1 \cdot {}_{\tau}\overline{X} + |\hat{E}(k)|)^2$
Yes
D315
$m++$
D316
$\hat{X}(k) = SIGN(\hat{E}(k)) \cdot (C_1 \cdot {}_{\tau}\overline{X} + |\hat{E}(k)|)$
D317
$k++$

FIG.11

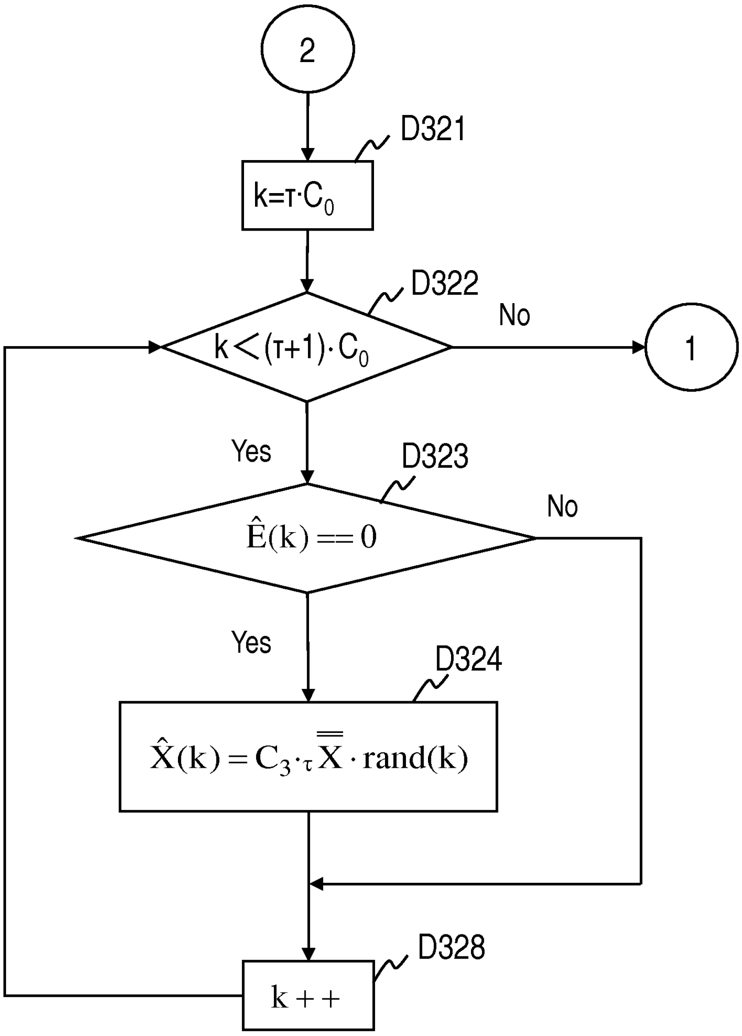
2
D321
k=τ·C0
D322
k<(τ+1)·C0
No
1
Yes
D323
Ê(k) == 0
No
Yes
D324
X̂(k) = C3·τ X · rand(k)
D328
k++

FIG. 12

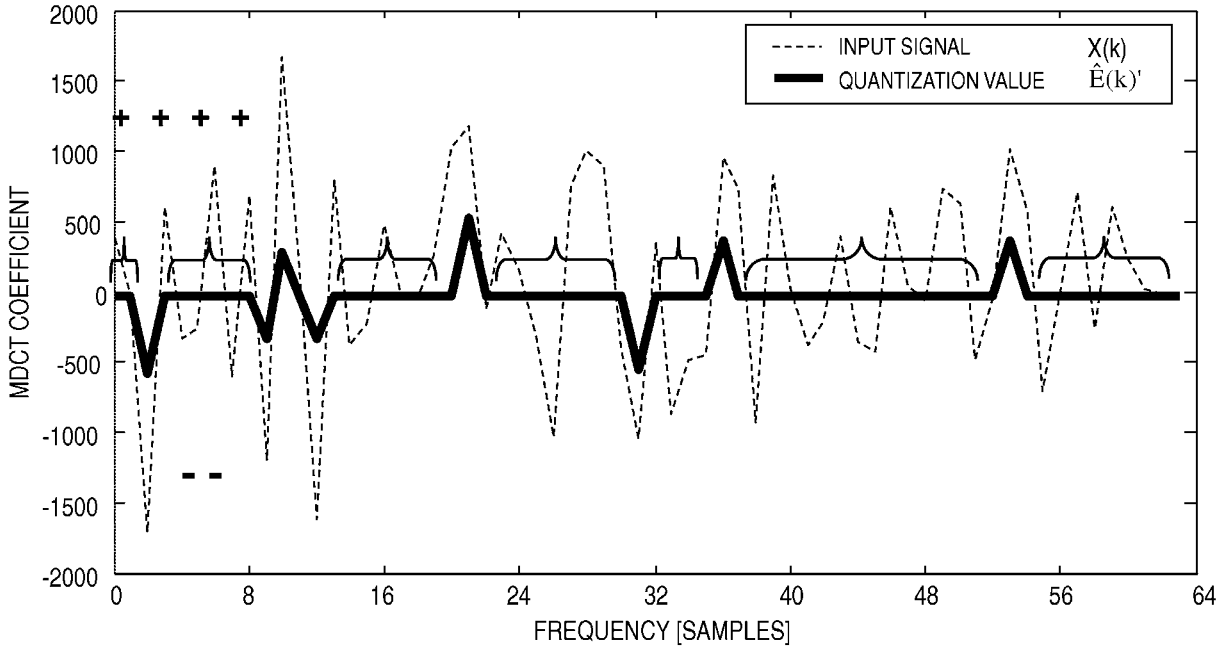
2000
1500
1000
500
0
-500
-1000
-1500
-2000
MDCT COEFFICIENT
0
8
16
24
32
40
48
56
64
FREQUENCY [SAMPLES]
INPUT SIGNAL
X(k)
QUANTIZATION VALUE
Ê(k)'
+ + + +
- -

**INTERNATIONAL SEARCH REPORT**

International application No.
PCT/JP2011/065273

A. CLASSIFICATION OF SUBJECT MATTER
*H03M7/30*(2006.01)i, *G10L19/02*(2006.01)i, *H04N7/26*(2006.01)i

According to International Patent Classification (IPC) or to both national classification and IPC

B. FIELDS SEARCHED

Minimum documentation searched (classification system followed by classification symbols)
H03M7/30, G10L19/02, H04N7/26

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2009/093714 A1 (Nippon Telegraph and Telephone Corp.), 30 July 2009 (30.07.2009), entire text; all drawings & US 2011/0044405 A & EP 2234273 A1 & CA 2711539 A & CN 101911501 A | 1-30 |
| A | JP 8-44399 A (Nippon Telegraph and Telephone Corp.), 16 February 1996 (16.02.1996), entire text; all drawings & US 5684920 A & EP 673014 A3 & EP 673014 A2 & DE 69518452 D & DE 69518452 T | 1-30 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 August, 2011 (17.08.11) | 30 August, 2011 (30.08.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No.
PCT/JP2011/065273

C (Continuation). DOCUMENTS CONSIDERED TO BE RELEVANT

| Category* | Citation of document, with indication, where appropriate, of the relevant passages | Relevant to claim No. |
|---|---|---|
| P,A | JP 2011-9869 A (Nippon Telegraph and Telephone Corp.), 13 January 2011 (13.01.2011), entire text; all drawings (Family: none) | 1-30 |
| P,A | JP 2011-9861 A (Nippon Telegraph and Telephone Corp.), 13 January 2011 (13.01.2011), entire text; all drawings (Family: none) | 1-30 |
| P,A | JP 2011-9860 A (Nippon Telegraph and Telephone Corp.), 13 January 2011 (13.01.2011), entire text; all drawings (Family: none) | 1-30 |
| P,A | JP 2011-9868 A (Nippon Telegraph and Telephone Corp.), 13 January 2011 (13.01.2011), entire text; all drawings (Family: none) | 1-30 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7261800 A